Europäisches Patentamt

European Patent Office

Office européen des brevets

(19)

(11) **EP 1 144 711 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(51) Int Cl.⁷: **C23C 14/06**, C09C 1/00, C23C 14/00

(21) Anmeldenummer: **00902543.8**

(22) Anmeldetag: **10.01.2000**

(86) Internationale Anmeldenummer:
**PCT/DE00/00053**

(87) Internationale Veröffentlichungsnummer:
**WO 00/043565 (27.07.2000 Gazette 2000/30)**

(54) **VERFAHREN UND VORRICHTUNG ZUR HERSTELLUNG VON FARBPIGMENTEN**

METHOD AND DEVICE FOR PRODUCING COLORED PIGMENTS

PROCEDE ET DISPOSITIF POUR PRODUIRE DES PIGMENTS COLORANTS

(84) Benannte Vertragsstaaten:
**DE ES FR GB IT**

(30) Priorität: **20.01.1999 DE 19902141**
**01.02.1999 DE 19903793**

(43) Veröffentlichungstag der Anmeldung:
**17.10.2001 Patentblatt 2001/42**

(73) Patentinhaber: **ECKART GmbH & Co. KG**
**D-90763 Fürth (DE)**

(72) Erfinder: **Weinert, Hilmar**
**87600 Kaufbeuren (DE)**

(74) Vertreter: **Rau, Manfred, Dr. Dipl.-Ing. et al**
**Rau, Schneck & Hübner**
**Patentanwälte**
**Königstrasse 2**
**90402 Nürnberg (DE)**

(56) Entgegenhaltungen:
**EP-A- 0 027 718       EP-A- 0 227 423**
**EP-A- 0 708 154       US-A- 3 895 156**
**US-A- 5 135 812**

• **PATENT ABSTRACTS OF JAPAN vol. 1997, no. 02, 28. Februar 1997 (1997-02-28) & JP 08 283879 A (LASER NOSHUKU GIJUTSU KENKYU KUMIAI), 29. Oktober 1996 (1996-10-29)**

**Beschreibung**

Die Erfindung betrifft ein Verfahren zur Herstellung von plättchenförmigen Farbpigmenten gemäß dem Oberbegriff der Patentanspruchs 1, eine Vorrichtung zur Durchführung des Verfahrens und nach diesem Verfahren hergestellte Farbpigmente.

Der gegenwärtige Stand der Technik benutzt verschiedene Methoden zur Erzeugung von plättchenförmigen Pigmenten, deren Anwendungsbereich hauptsächlich auf zwei Gebieten liegt:

A) Der Sicherheitsbereich für Banknoten, Dokumente und Verschlüssen von Lebensmittel- und Pharmazeutikverpackungen und

B) der dekorative Bereich der Effektlacke für Fahrzeugkarosserien und andere Produkte

Im Fall A ist eine ausgeprägte Farbveränderung des reflektierten Lichtes durch Interferenz in Abhängigkeit vom Einfallswinkel des weißen Lichtes erwünscht. Im Fall B ist die Zielrichtung, diese Änderung gering zu halten, aber mit demselben Verfahren nur durch Variation der Schichtdicke beliebige Farben des reflektierten Lichtes nach dem Interferenzprinzip zu erzeugen. Nach dem Stand der Technik werden heute die meisten Metallic-Farben dadurch hergestellt, daß ein feines Aluminiumpulver im Lack mit einen transparenten, organischen Farbstoff vermischt wird. Der organische Farbstoff bestimmt die Wellenlängen der absorbierten Farben; die Partikel aus Aluminiumpulver erzeugen die Reflexion in der Lackschicht. Es ist ersichtlich, daß für jede solche Metallic-Farbe ein anderer organischer Farbstoff zu wählen ist, welcher sich in der Herstellung und in seiner chemischen Zusammensetzung unterscheidet.

Als Beispiel für ein Produkt im Sicherheitsbereich beschreibt die US 5 278 590 ein 3-Schichtsystem aus je einer Chromschicht mit 20-50% Transmission und einer dazwischenliegenden Schicht aus transparentem Magnesiumfluorid im Bereich einer optischen Dicke von 150 bis 950 Nanometer. Dieses Plättchen-Pigment besitzt eine starke Farbänderung bei Neigung. Eine 45°-Neigung verschiebt zum Beispiel das Reflexionsmaximum von 550 auf 475 Nanometer. Dieses Pigment ist lichtdurchlässig, was seine Verwendung in Lacken einschränkt.

Ein weiteres Produkt, hergestellt nach der US 5 135 812 stellt ein 5-Schichtsystem dar. Es werden nach diesem Verfahren auf einer Trägerfolie nacheinander im Vakuum aufgedampft: eine halb-lichtdurchlässige Chromschicht, eine Magnesiumfluoridschicht und eine opake Aluminiumschicht, die als Reflektor dient. Aus Symmetriegründen ist dieselbe Schichtenfolge von Magnesiumfluorid und Chrom exakt gleicher Dicke noch einmal zu wiederholen, da die so erzeugten Pigment-Plättchen in einer Lackschicht oder in einer Druckfarbe auf jeder der zwei Seiten zum Liegen kommen können.

Die nach diesem Verfahren hergestellten Farbpigmente haben fünf Schichten, wobei die zweite und vierte Schicht (Magnesiumfluorid) die Interferenzfarbe bestimmen, die dritte (Aluminium) als Reflektor dient, und die erste und die fünfte Schicht (Chrom) den absorbierenden Teil-Reflektor bilden. Die Dicke der Chromschicht bestimmt die Intensität der reflektierten Farbe. Zu dünne Chromschichten ergeben fahle Farben, zu dicke führen zu einem metallisch grauem Aussehen.

Dieses Schichtsystem ist anzusehen als ein beidseitig reflektierender Fabry-Perot-Filter. Nach J. Rancourt "Optical Thin Films User's Handbook", ISBN Nr.0-07-051199-3 Seite 107-108 zeigt sich, daß der Brechungsindex der transparenten Schichten möglichst niedrig sein soll, um bei einer gegebenen Änderung des Lichteinfallwinkels eine große Änderung der reflektierten Farbe auszulösen. Bei einer Neigung um 45° verschiebt sich die Wellenlänge des Reflexionsmaximums gegenüber 0° um :

n = 1.38 ( Magnesiumfluorid ) : 15 %

n = 2.4 (Beispiel Titandioxid): 5 %

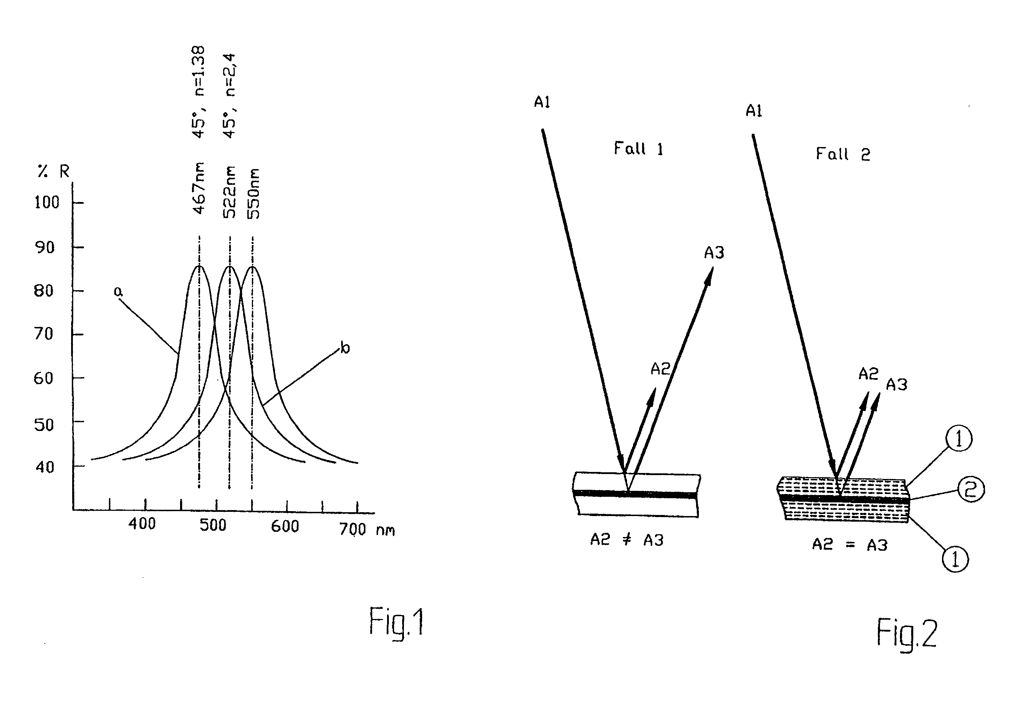

**Fig. 1,** auf die bereits jetzt verwiesen wird, soll diesen Effekt anhand eines klassischen Fabry-Perot-Filters qualitativ verdeutlichen. Die drei Kurven 0°, (a) und (b) zeigen als Beispiel die Reflexion der Schichtenfolge Silber-Magnesiumfluorid-Silber (Kurve a) und Silber-Titandioxid-Silber (Kurve b) über der Wellenlänge bei 0° und 45° Neigung. Das Maximum der Reflexion wandert bei einem Kippwinkel von 45° im ersten Fall von 550 auf 467 Nanometer, im zweiten Fall von 550 auf 522 Nanometer. Die Schichtdicke der transparenten Schicht beträgt in **Fig. 1** jeweils d= $3\lambda/4n$. Der besseren Übersichtlichkeit wegen wurden die beiden Kurven für 0° hier deckungsgleich angepaßt.

Zur Erzeugung der Pigmentplättchen wird die Aufdampfschicht von der Trägerfolie in einem weiteren Schritt abgelöst oder gemäß der US 4 434 010 wird die Trägerfolie insgesamt aufgelöst. Nach weiteren Schritten, wie Waschen und Mahlen liegt das gewünschte Pigment als feine Plättchen vor.

Zum Stand der Technik gehört auch ein Verfahren nach der DE 4017220 A1, bei welchem statt einer aufgedampften Schichtenfolge von Cr-$MgF_2$-Al-$MgF_2$-Cr, wie in der US 5 135 812 beschrieben, die $MgF_2$-Schicht durch eine etwa gleich dicke Lackschicht mit einem ähnlichen Brechungsindex ersetzt wird.

Nachteilig bei derartigen Farbpigmenten ist, daß die organische Zwischenschicht bei Verwendung des Pigmentes in einem Lack von dessen Lösungsmitteln in den meisten Fällen angegriffen würde.

Ausgeprägte, winkelabhängige Farbänderungen sind, von wenigen Ausnahmen abgesehen, bei der Verwendung für Fahrzeuglacke mit einem metallisch-farbigem Aussehen und für die meisten Effektlackierungen dekorativer Art unerwünscht. Eine Effektfarbe eines Fahrzeuges oder eines anderen Objektes soll unter jedem Blickwinkel dem menschlichen Auge nur geringe, dezente Änderungen der Farbe zeigen. Nach der EP 0803549 A2 läßt sich ebenfalls ein farbiges 3-Schichtsystem des Typs SiOx-metallischer Reflektor-SiOx herstellen, wobei der Wert x zwischen 0.25 und 0.95 liegt. Es ist hierbei notwendig, Siliziummetall als Ausgangsmaterial reaktiv zu verdampfen. Der hierzu notwendige Sauerstoff-Partialdruck beträgt für x= 0.25 nach Erfinderangabe 3.0x10-4 Pa und die Auftragsgeschwindigkeit beträgt 0.2 Nanometer pro Sekunde. Für x=0.95 ist ein Sauerstoffpartialdruck von 1.9 x 10-3 Pa erforderlich.

Während diese Bedingungen leicht erfüllbar sind, wenn in einer Chargenanlage auf kleine Folienstücke von wenigen Quadratdezimetern aufgedampft wird, sind die genannten Bedingungen in einer Produktionsanlage, in welcher ein Trägerband bei wirtschaftlichen Geschwindigkeiten von 2-5 Metern pro Sekunde im Vorbeilauf an den Verdampfern beschichtet werden muß, nicht verwirklichbar. Die Verweilzeit in einem Dampfkegel von ca. 0.3 Metern Durchmesser am Kondensationsort würde demnach nur 0.06 bis 0.15 Sekunden betragen. Die Auftragsdicke wäre demnach maximal 0.2 Nanometer/sec x 0.15 sec = 0.03 Nanometer, anstelle der für Interferenzeffekte erforderlichen 75 bis 450 Nanometer geometrischer Dicke. Die angegebenen Vakua von $1.9 \times 10^{-3}$ bis $3 \times 10^{-4}$ Pascal sind in einer Bandbedampfungsanlage nicht verwirklichbar. Typische Arbeitsvakua sind $3 \times 10^{-2}$ Pa bei einer installierten Pumpkapazität der Diffusionspumpen von 50.000 Liter/sec. Die Kapazität der Diffusionspumpen müßte demnach auf 750.000 Liter/sec. erhöht werden, und die Bandgeschwindigkeit müßte auf 0,0008 m/sec abgesenkt werden, um wenigstens eine Schichtdicke von 75 Nanometern bei den in der EP 0803549 A2 genannten Bedingungen zu erzielen.

In der WO 93/08237 ist die Erzeugung von Plättchen-Pigmenten beschrieben, wobei in einem nassen Verfahren durch Walzenauftrag von zum Beispiel flüssigen organischen Siliziumverbindungen auf ein Band, Trocknen und Einbrennen des Auftrags, Einfärben mit organischen Farbstoffen und Ablösung der Plättchen vom Band ein farbig transparentes Produkt hergestellt wird. Dieses kann dann in einem weiteren Verfahren durch Schüttgutbedampfung oder durch chemische Abscheidung mit einer halb-lichtdurchlässigen Metallschicht beidseitig überzogen werden. Das so erzeugte Produkt ist ähnlich dem nach US5278590.

Nachteilig bei diesem Verfahren wie auch bei demjenigen gemäß der Patente US 5 135 812 und US 5 278 590 sind außenliegende Metallschichten, die in einem eigenen Prozeßschritt hergestellt werden müssen und die nicht so korrosionsfest sind wie eine Oxidschicht, auch wenn sie in einem Lack eingebettet verwendet werden.

Die Schichtdicken der äußeren, halb-lichtdurchlässigen Metallschichten gemäß der WO 93/08237, welche die Farbe bestimmen, lassen sich bei einer Schüttgutbeschichtung nicht so präzise kontrollieren wie bei einem PVD-Aufdampfverfahren, welches einen Träger verwendet. Die erzeugten Reflexionsfarben sind deshalb eine Mischung aus verschiedenen Interferenzfarben. Eine ausgeprägte Winkelabhängigkeit der Reflex-Farben liegt vor, da die nach der WO 93/08237 erzeugte transparente Schicht einen niedrigen Brechungsindex von weniger als n=1,6 aufweist.

Ein weiteres Verfahren nach EP 0708154 A2 erzeugt auf naßchemischen Weg auf Aluminiumteilchen zuerst eine Quarzschicht mit einem niedrigen Brechungsindex und danach eine hochbrechende Oxidschicht aus Eisenoxid ($Fe_2O_3$) in einem Fließbett, in welchem in einem Trägergas unter Sauerstoffzugabe bei 200°C Eisencarbonyl sich zu Eisenoxid umwandelt und sich als Film auf den mit Quarz vorbeschichteten Aluminiumplättchen niederschlägt. Die Aluminiumplättchen werden als Ausgangsmaterial entweder nach bekannten Mahl- und Schleifverfahren hergestellt oder nach dem CVD-Verfahren nach DE 19516181 A1 durch Abscheidung von Aluminium aus einer organischen Aluminiumverbindung auf einem bereits vorhandenen Trägerplättchen hergestellt. Eisenoxid besitzt in der Durchsicht eine leicht gelbe Eigenfarbe und begrenzt die Verwendung dieser Pigmente auf Gelb/Orange/Rot-Töne.

Bei einem weiteren Verfahren gemäß der DE 19525503 A1 werden in 2 Stufen auf nichtmetallischen Plättchen nach einem naßchemischen Verfahren eine niedrigbrechende Schicht aus z.B. $SiO_2$, gefolgt von einer nach einem CVD-Verfahren hergestellten Schicht aus einem reflektierenden, selektiv oder nicht selektiv absorbierenden, teilweise durchlässigen Schicht, gefolgt von einer nach einem weiteren Verfahren hergestellten äußeren Schutzschicht gegen Korrosion oder Abrieb hergestellt.

Die so erzeugten chemisch erzeugten Pigmente besitzen zwar den gewünschten, mäßigen Farb-Kippeffekt aufgrund der hohen Brechungsindizes der aufgebrachten Schichten von n=3.0 für $Fe_2O_3$. Eisenoxid besitzt aber als dünne Schicht eine starke selektive Absorption im Gelb/Rotbereich. Es eignet sich deshalb nur zur Herstellung von Pigmenten, die in diesem Farbbereich liegen. Die Auftragung der Oxidschichten im Fließbett erfolgt jedoch im Gegensatz zu einer Aufdampfung unter Vakuum mit einer gewissen statistischen Verteilung der Schichtdicke. Nachmessungen an Pigmentteilchen ergeben eine beträchtliche Farbstreuung im reflektierten Licht von zum Beispiel blassgelb bis rot-orange zwischen einzelnen Partikeln. Dies bedeutet Dickenunterschiede der Oxidschicht von +/-12%.

Bei geeigneter Technik und Prozeßführung der Aufdampfung auf einen kontinuierlich laufenden Träger sind jedoch Dickenunterschiede von +/ 2% realisierbar. Chemisch beschichtete Pigmente werden deshalb meistens nur in Kombination mit anderen Pigmenten eingesetzt, deren Farbe auf einer selektiven Absorption des Lichtes durch ihre chemischen Struktur und ihre Bindungsart der Atome beruhen. Während nach dem Aufdampfverfahren hergestellte Plättchen eine Oberflachenrauhigkeit aufweisen, die der des Trägerbandes entspricht und die weniger als Rz=0,01μ betragen kann, sind mechanisch oder chemisch hergestellte Aluminiumplättchen voll von Oberflächendefekten. Lokale Farbabweichungen und Lichtstreuung sind die Folge.

Nachteilig bei allen vorbeschriebenen Verfahren ist , daß sie entweder nicht in der Lage sind, die gesamte Palette von für das menschliche Auge unterscheidbaren Farben, Tönungen und Helligkeitsgraden herzustellen, entweder aus fünf Einzelschichten bestehen müssen oder in mehreren Stufen in mehreren chemischen oder CVD-Verfahren hergestellt werden müssen. Letztere sind, mit wenigen Ausnahmen, auf die Beistellung von Plättchensubstraten angewiesen.

Auch für anorganische, transparente, farbige Pigmente auf Interferenzbasis sind nach dem Stand der Technik verschiedene Herstellverfahren bekannt.

So zeichnen sich oxidische Interferenzschichten dadurch aus, daß diese frei von Schwermetallen sind und eine sehr gute thermische und chemische Beständigkeit haben. Da die Schichten dieser Pigmente dünn sind, tritt bei Veränderung des Lichteinfallwinkels durch die Änderung des Weglänge des Lichtstrahles immer eine gewisse Farbveränderung auf. Eine Zusammenstellung des Standes der Technik wurde von R. Schmid, N. Mronga unter "Luster Pigments with Optically Variable Properties" veröffentlicht (4. Nürnberg Kongress, 7-9 April 1997 des European Coatings Net). Dieser Artikel ist im Internet unter www.coatings.de/articles/schmid/schmid.htm wiedergegeben.

Schichtsysteme mit innenliegenden, transparenten Schichten haben entsprechend der US 3,438,796 die Schichtfolge Al-SiO$_2$-Al und entsprechend der EP 0395 410B1 die Schichtfolge Cr-MgF$_2$-Cr und weisen außenliegende Schichten auf, die semi-transparent sind.

Aus der Offenlegungsschrift DE19618569 ist die Schichtfolge TiO$_2$-SiO$_2$-TiO$_2$ bekannt, die auf einen Naturglimmeroder synthetischen SiO$_2$-Träger chemisch aufgetragen werden. Hierbei handelt es sich um ein Verfahren in 2 Schritten, bei dem nicht die gute Gleichförmigkeit der Schichtdicke, Planparallelität und Oberflächengüte wie bei einem nach dem PVD-Verfahren erzeugten Plättchen erreicht wird. Das so erzielte Produkt hat ein pastellfarbiges Aussehen, keine tiefe Farbe und ist unter dem allgemeinen Namen "Perlglanzpigment" bekannt.

Weitere Produkte besitzen die Schichtfolge Fe$_2$O$_3$-SiO$_2$-Glimmer-SiO$_2$-Fe$_2$O$_3$.

Schichtsysteme können einen inneren metallischen Reflektor aufweisen, auf welchem beidseitig je eine transparente Schicht mit einem niedrigen Brechungsindex von <1.7 aufgebracht ist, gefolgt von einer absorbierenden, halblichtdurchlässigen Deckschicht. Eine Deckschicht aus Chrom von 8 Nanometer Dicke nach EP 0227 423B1 und eine Deckschicht aus einer selektiv absorbierenden Schicht aus gewissen Metalloxiden oder einem Farbmittel nach EP0708154A2, sind Beispiele hierfür.

Farbfülle ist nicht allein nur mit transparenten Schichten mit abwechselnd hohem und niedrigem Brechungsindex zu erzielen. In den Patenten WO97/39065 und US5,693,135 ist beschrieben, daß außenliegenden, hochbrechenden Schichten durch Reduktion des chemisch aufgetragenen Titandioxid absorbierend gestaltet werden. Hierbei wird auf in einem Vorläuferprozess erzeugte Quarzplättchen (SiO$_2$) mit einem Brechungsindex von n=1.5 beidseitig eine TiO$_2$-Schicht mit n=2.4 chemisch aufgetragen. Danach werden die Plättchen bei einer Temperatur von 500°C bis 1000°C in einem Fließbettreaktor einem Gemisch aus Wasserstoff und Ammoniak ausgesetzt, wodurch eine teilweise Reduktion des Titandioxids zu einem Titansuboxid, wie z.B. Ti$_4$O$_7$, Ti$_3$O$_5$ eintritt.

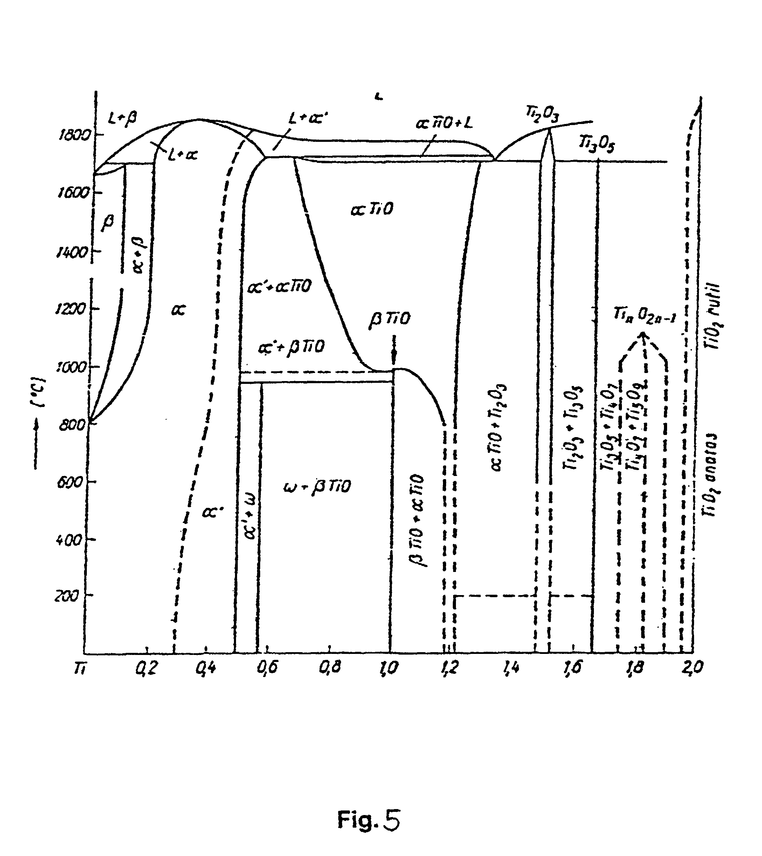

Die Vielzahl der möglichen Titan-Sauerstoff-Verbindungen zeigt das Phasendiagramm des Systems Ti$\Leftrightarrow$TiO$_2$ in **Fig. 5** (tschechische Veröffentlichung: Chemicky promysi, 17/42/1967, Seite 185). Unzersetzt verdampfbar ist bei hohen Geschwindigkeiten nur das TiO. Alle Ti$_x$O$_y$ mit höherem Sauerstoffgehalt von y>x dissoziieren bis zum TiO. Der freigesetzte Sauerstoff würde aufgrund der großen Mengen bei technischen Prozessen, die eine Verdampfung von mehreren Kilogramm pro Stunde benötigen, keine Aufrechterhaltung eines Hochvakuumbetriebes mehr zulassen. Alle Suboxide haben als dünne Schicht eine gewisse Eigenabsorbtion des Lichtes, welche die Farbfülle des reflektierten Lichtes steigert. Nachteilig hierbei ist, daß die Suboxide des Titans die Tendenz haben, sich bei Anwesenheit von Luftsauerstoff, Wärme und Zeit wieder zu TiO$_2$ mit Anatas-Struktur zu oxidieren. Ein Beispiel hierfür ist eine Meßreihe an einem mittels eines PVD-Verfahrens hergestellten Schichtsystems, bei welchem Titan-Monoxid (TiO) verdampft wurde. Die optische Transmissionmessung zeigte:

- unmittelbar nach Aufdampfung des 3-Schichtsystems TiO-SiO-TiO: T=5.69 % (bei p=1x10$^{-4}$mbar und vor Lufteinlaß in die Vakuumkammer)
- 1 Minute nach Lufteinlaß, an der Atmosphäre (20°C, 70% rel. Luftfeuchtigkeit): T=69.8 %
- 4 Minuten später: T=77.9 %
- 10 Minuten später: T=80.5 %
- gefolgt von 20 Minuten Tempern bei 200°C: T= 88.0 %

Diese Werte beziehen sich auf die Aufdampfschicht allein ohne das Glassubstrat. Mit Glassubstrat sind die Werte um den Faktor 0.92 geringer.

Eine weitere Erhöhung der Temperatur führte zu keiner weiteren Erhöhung der Transparenz. Es zeigt sich, daß ein Schichtsystem, das Suboxide des Titans enthält, seine Absorption zeit- und temperaturabhängig verringert. Das Ergebnis ist ein Nachlassen der Farbfülle. Nachteilig ist ferner bei den genannten chemischen Verfahren, daß im Gegensatz zum PVD-Verfahren eine genaue Kontrolle der Schichtdicken nicht möglich ist. Die Beschichtungen erfolgen in einem Haufwerk, meistens in einem Fließbett. Sie führen zu Farbunterschieden zwischen einzelnen Plättchen. Zur Herstellung dieser Pigmente werden Verfahren mit drei Stufen in verschiedenen Apparaten eingesetzt und es werden Wasserstoff, Ammoniak und Titantetrachlorid verwendet.

Demgegenüber liegt der Erfindung die Aufgabe zugrunde, ein Verfahren und eine Vorrichtung zur Herstellung von Farbpigmenten zu schaffen, mit denen unterschiedliche Farbeffekte einfach und reproduzierbar einstellbar sind.

Diese Aufgabe wird hinsichtlich des Verfahrens durch die Merkmale des Patentanspruchs 1 bezüglich der Farbpigmente durch die Merkmale des Patentanspruchs 18 gelöst.

Erfindungsgemäß wird das Farbpigment durch Aufbringen einer Mischschicht auf einer Reflexionsschicht hergestellt. Die Mischschicht besteht aus einem eine transparente Schicht bildenden Material und einem lichtabsorbierenden Material, wobei durch geeignete Wahl des Brechungsindex des erstgenannten Materials und durch Einstellung des Anteils an lichtabsorbierendem Material die Farbintensität und die Farbtönung des Farbpigments auf einfache Weise eingestellt werden kann. Es ist daher nicht erforderlich, wie beim vorbeschriebenen Stand der Technik, die außenliegenden Schichten als halblichtdurchlässige Metallschichten auszubilden.

Der verfahrenstechnische Aufwand ist besonders gering, wenn die Reflexionsschicht und die Mischschicht durch Aufdampfen aufgebracht werden, wobei das lichtabsorbierende Material dem transparenten Material durch gleichzeitige Verdampfung unter Vakuum beigemischt wird. Das Mol-Verhältnis des lichtabsorbierenden Materials zum transparenten Material beträgt vorzugsweise zwischen 1 und 50 %.

Die Herstellung ist besonders einfach, wenn die Mischschicht durch zwei Verdampfer erzeugt wird, deren Dampfstrahlen einander überlappen, so daß im Überlappungsbereich die Mischschicht hergestellt wird.

Alternativ dazu kann die Verdampfung auch über einen einzigen Verdampfer erfolgen, der beide Komponenten gleichzeitig oder wechselnd verdampft.

Als Verdampfer werden vorzugsweise widerstandsbeheizte, mit Elektronenstrahlen beheizte, induktiv beheizte oder mit einem Lichtbogen betriebene Verdampfer eingesetzt. Als besonders gut geeignete Materialen zur Herstellung der Reflexionsschicht, der transparenten Schicht und der lichtabsorbierenden Schicht haben sich die in den Patentansprüchen 3 bis 6 angegebenen Materialien und Zusammensetzungen herausgestellt.

Die Mischschicht aus lichtabsorbierendem Material und transparentem Material kann auf beiden Seiten der Reflexionsschicht oder auf lediglich einer Seite der Reflexionsschicht des Farbpigments aufgebracht werden. D. h., im erstgenannten Fall besteht das Farbpigment aus drei Schichten, während es im letztgenannten Fall lediglich aus zwei Schichten besteht.

Das erfindungsgemäße Verfahren und die erfindungsgemäße Vorrichtung lassen sich weiter vereinfachen, wenn die Schichten auf ein Trägermaterial aufgebracht werden, wobei zwischen Trägermaterial und dem Schichtaufbau vorzugsweise ein Trennmittel aufgebracht wird. Dieses erleichtert das Abtrennen des Schichtaufbaus vom Trägermaterial.

Gemäß einer ersten Alternative kann das Trägermaterial sowohl die Reflexionsschicht als auch die Mischschicht (transparentes Material, lichtabsorbierendes Material) tragen oder aber lediglich die Reflexionsschicht, die dann vom Trägermaterial abgelöst und anschließend mit der Mischschicht versehen wird.

Das Trennmittel zwischen dem Trägermaterial und dem Schichtaufbau kann im gleichen Vakuumprozeß vor dem Aufdampfen des Schichtverbundes aufgetragen werden.

Zur Vereinfachung des Abtrennens sollte das Trägermaterial eine glatte oder eine strukturierte Oberfläche aufweisen.

Als besonders gut geeignet für das Trägermaterial haben sich eine Polyimidfolie oder eine Folie aus Metall oder aus einer Kombination dieser Materialien herausgestellt.

Es wird bevorzugt, wenn das Trägermaterial umlaufend als Band ausgebildet ist, so daß eine kontinuierliche Farbpigmentfertigung ermöglicht wird.

Anstelle des Aufdampfens der Mischschicht (transparentes Material, lichtabsorbierndes Material) kann die Abscheidung auf der Reflexionsschicht auch durch ein chemisches oder physikalisches Verfahren erfolgen. Wesentlich ist dabei, daß die beiden Materialien möglichst gleichzeitig auf die Reflexionsschicht aufgebracht werden.

Die Qualität der hergestellten Farbpigmente läßt sich weiter verbessern, wenn sich an die Herstellung des Schichtaufbaus eine oxidativ-thermische Nachbehandlung der Farbpigmente, insbesondere des transparenten Materials anschließt.

Sonstige vorteilhafte Weiterbildungen der Erfindung sind Gegenstand der weiteren Unteransprüche.

Im folgenden werden bevorzugte Ausführungsbeispiele der Erfindung anhand schematischer Zeichnungen näher erläutert.

Es zeigen:

Fig. 1    ein Diagramm zur Veranschaulichung der Reflexion eines Referenzschichtaufbaus in Abhängigkeit von der Wellenlänge und der Neigung des einfallenden Lichtes;

Fig. 2    eine schematische Darstellung der Lichtreflexion bei einem herkömmlichen Material und bei einem erfindungsgemäßen Farbpigment;

Fig. 3    eine erfindungsgemäße Vorrichtung zur Durchführung des Verfahrens;

Fig. 4    die Reflexion in Abhängigkeit von der Wellenlänge des einfallenden Lichtes bei unterschiedliche, erfindungsgemäßen Schichtzusammensetzungen und

Fig. 5    ein Phasendiagramm des Systems Ti⇔$TiO_2$ zur Darstellung der Vielzahl der möglichen Titan-Sauerstoff-Verbindungen.

Die im folgenden beschriebene Erfindung ermöglicht es, alle Schichten, einschließlich des Substrates in einem einzigen Arbeitsgang kontinuierlich herzustellen. Dabei werden nacheinander ein erstes und ein zweites Ausführungsbeispiel abgehandelt.

Erstes Ausführungsbeispiel

Durch das erfindungsgemäße Verfahren wird ein in Lacken und Druckfarben verwendbares Effekt-Pigment als Plättchen durch Verdampfung von Metallen und Oxiden im Vakuum hergestellt. Das Pigment kann in über 1000 unterscheidbaren und reproduzierbaren Farb- und Farbtonvarianten hergestellt werden durch Veränderung von nur zwei Prozeßparametern: der Dicke der Vakuumbeschichtung einer transparenten Schicht und des Anteils eines darin eingebetteten absorbierenden Materials.

Das Produkt ist eine 2- oder 3-Schicht-Kombination aus einer Reflexions- und je einer hochbrechenden, transparenten Schicht auf einer oder beiden Seiten und besitzt eine nur geringe Veränderung der reflektierten Farbe in Abhängigkeit vom Einfallswinkel des Lichtes.

Zur Veränderung der Farbintensität und der Farbtons der reflektierten Farben werden in die hochbrechende, transparente Schicht gezielt absorbierende Materialien eingebracht. Die Pigmentplättchen zeichnen sich durch ein sehr günstiges Oberfläche/Masseverhaltnis von typisch 2,2 Gramm pro Quadratmeter aus.

Bei einem bevorzugten Ausführungsbeispiel des erfindungsgemäßen Verfahrens werden unter Vakuum, vorzugweise im Druckbereich von 1 bis $10^{-3}$ Pa durch thermische Verdampfung nach dem PVD-Verfahren nacheinander aufgebracht:

-    eine an der Oberseite angeordnete Mischschicht (siehe Fig. 2) aus einem Oxid oder Suboxid mit einem frei wählbaren Anteil eines absorbierenden Materials welches durch gleichzeitige Verdampfung aus einer weiteren oder aus derselben Quelle eingebracht wird

-    eine metallische Reflektorschicht 2 und

-    eine weitere Mischschicht 1 an der Unterseite des Farbpigments.

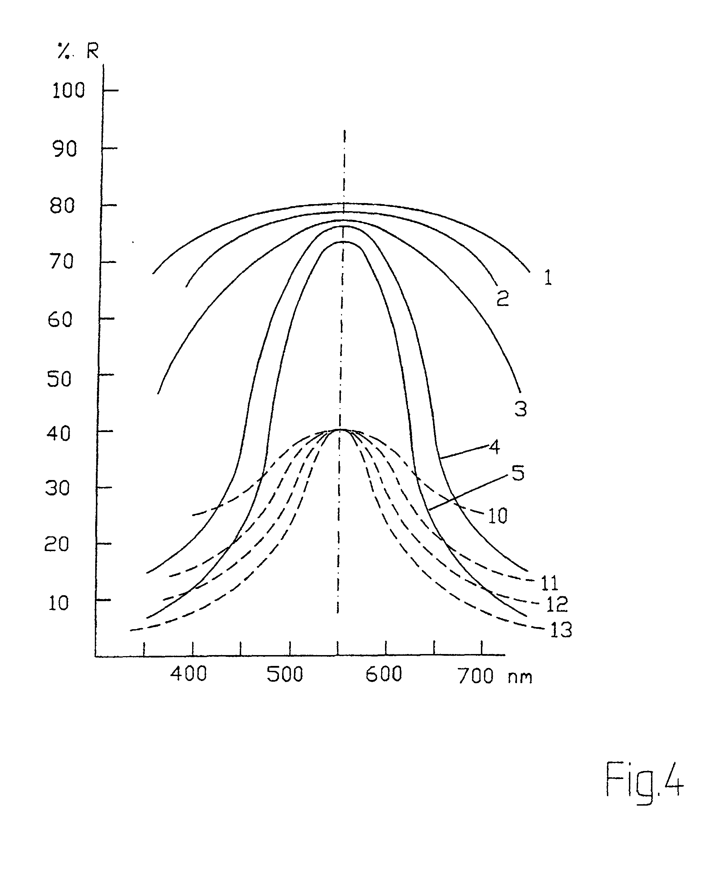

Die untere Mischschicht 1 wird aus Symmetriegründen benötigt, da die Plättchen-Pigmente in einem Lack sich nach jeder der beiden Seiten ausrichten können. Das so geschaffene Schichtsystem weicht wesentlich vom Prinzip des Fabry-Perot Filters ab. Die Schichtdicke der Mischschicht 1 bestimmt die reflektierte Farbe gemäß ihrer optischen Dicke nd=zλ/4, wobei z 1, 2 oder 3 sein kann. Höhere Ordnungen von z>3 führen nur noch zu fahlen Farben. Das in die hochbrechende Mischschicht 1 eingebrachte absorbierende Material hat erfindungsgemäß die Funktion, die an den Grenzflächen Luft-hochbrechendes Material und hochbrechendes Material-Reflektor reflektierten Amplituden des einfallenden Lichtes zu beeinflussen. Sind diese gleich, wird nach Fig. 4, auf die bereits hier hingewiesen sei, die maximale Intensität, auch maximal mögliche Farbfülle genannt, der reflektierten Farbe erzielt. Diese Funktion erfüllt beim Fabry Perot Filter die zusätzlich notwendige, außenliegende Metallschicht durch ihre dickenabhängige Lichtdurchlässigkeit.

Die physikalischen Zusammenhänge, die den Effekt der Beimischung des absorbierenden Materials mit verschiedenen Molanteilen zum Material der hochbrechenden Schicht zeigt, erläutert **Fig. 4** und die Gleichungen Gl 1, 1a und 2.

Demgemäß ist es möglich, eine sehr breite Farb- und Farbtönungspalette von Pigmentplättchen zu schaffen. Die Forderungen, die das neue Verfahren erfüllt, sind im Wesentlichen:

-    Herstellung einer großen Anzahl von Reflexionsfarben, Hell- und Dunkeltönen und Farbintensitäten nach einem einzigen, leicht variiierbaren Verfahren mit nur zwei Verdampfungsmaterialien, von denen die Dicke der transparenten Substanz durch Interferenz die Farbe, und der Molanteil der absorbierenden Substanz die Intensität der Farbe und die Tönung bestimmen.

-    Geringste Farbunterschiede durch eine gute Reproduzierbarkeit der Schichten und unterbrechungsfreie Umstellung der Produktion von einer Plättchenfarbe oder Farbtönung auf eine andere nur durch Veränderung der Verdampfungs-leistung und/oder der Trägerbandgeschwindigkeit

- Chemische Beständigkeit des Produktes gegen Korrosion und Abrieb, durch außenliegende Oxidschichten großer Härte
- Kontinuierliches Verfahrens bei nur drei Schichten zur Herstellung von doppelseitig gleichen Plättchen- Pigmenten in einer einzigen Apparatur.
- Ein die Umwelt nicht belastendes Verfahren; es kommen keine gasförmingen oder flüssigen Ausgangsprodukte und Abfallsprodukte vor. Die Apparatur, eine Vakuumanlage, ist gasdicht gegen die Umgebung abgeschlossen.

Erfindungsgemäß wird dies erreicht durch thermisches Aufdampfen nach dem PVD-Verfahren auf ein unter Vakuum von einer Rolle zu einer anderen laufendes Band einer Schichtenfolge nach **Fig. 2** aus der hochbrechenden, transparenten Mischschicht 1, in welche ein absorbierendes Material in der Dampfphase zugemischt wird, gefolgt von einer Reflexionsschicht 2 und gefolgt von einer weiteren Mischschicht 1 gleicher Schichtdicke. Die Anordnung der Schichten 1, 2, 1 ist notwendig, um dem Pigment-Plättchen gleiches Aussehen an beiden Oberflächen zu geben.

Als Aufdampfmaterialien eignen sich als Ausgangsmaterial solche, die nach kompletter Oxidation hochbrechende, transparente, harte und chemisch beständige Mischschichten 1 bilden, mit einem Brechnungsindex von n>2.0 und keiner oder nur geringer Eigenfarbe: Titanmonoxid (TiO), $Ti_2O_3$, $Ti_3O_5$, Nioboxid, Zirkonmonoxid (ZrO), Cermetall oder Cer-Mischmetall, gefolgt von einer Reflexionsschicht aus Al, Cr, Fe, Ti, Ni, 2 und einer weiteren Mischschicht 1.

Die Substanzen der Mischschicht 1 müssen in einen kontinuerlichen Aufdampfverfahren auf ein vorbeilaufendes Trägerband aus wirtschaftlichen Gründen mit einer sehr hohen Geschwindigkeit aufgetragen werden, da die Aufdampfschichten selbst das Produkt darstellen, im Gegensatz zu bedampften Teilen, bei welchen die Schicht nur eine Funktion erfüllt.

Eine reaktive Verdampfung unter Sauerstoffzufuhr scheidet aus. Solche Verfahren, wie sie von optischen Bedampfungen von Filtern, Linsen und Brillengläsern bekannt sind, erlauben höchstens einen Auftrag von 5 Nanometern pro Sekunde, während wirtschaftliche Erwägungen bei der Pigment-Plättchenerzeugung 100 bis 500 mal höhere Werte verlangen, um technische Mengen von etwa 5 bis 20 kg pro Stunde des Produktes erzeugen zu können.

Die bei derart hohen Verdampfungsgeschwindigkeiten erzielten Schichten sind jedoch nicht transparent, sondern noch stark absorbierend und zeigen vorerst wenig Reflexionsfarben. Sie entsprechen stöchiometrisch weitgehend dem verdampften Suboxid, oder sie haben im Kondensat einen noch geringeren Sauerstoffgehalt als das Ausgangsmaterial, da eine teilweise Dissoziation auftreten kann. Deshalb ist es notwendig, die Pigmentplättchen nach dem Ablösen vom Trägerband nach bekannten Verfahren einer oxidativ-thermischen Behandlung an Luft von etwa 5 bis 10 Minuten Dauer bei vorzugsweise 200 bis 300°C in einem durchströmten Haufwerk zu unterwerfen.

Würde nur das Oxid oder Suboxid allein verdampft werden, entstünden zwar die gewünschten hochbrechenden, transparenten Schichten (1) nach Fig. 2 auf dem Reflektor (2) und die durch den Gangunterschied zwischen der Reflexion an der Grenzfläche Luft-Oxid und der Grenzfläche Oxid-Reflektor erzeugten Interferenz, jedoch ist damit die Amplitudengleichheit beider Wellen noch nicht gegeben. Diese bestimmt die Intensität der reflektierten Farbe.

Alle verdampfbaren Oxide ohne Eigenfarbe und mit guter chemischer Beständigkeit haben Brechungsindices zwischen n=2.0 und n=2.4. Nach Mayer, Physik dünner Schichten (1950), S. 243 ergibt sich Gleichung 1a für die Reflexion einer Schicht mit einem Brechnungsindex von n1=2.4, wenn sie in einem transparenten Medium mit n2=1.5 eingebettet ist. Dies ist genau der Fall bei einem Pigment, welches in einem Klarlack eingebettet ist. Diese Plättchenpigmente sind bestimmungsgemäß vorgesehen zur Einbettung in Lacke für Druckfarben und Oberflächenlackierungen. Sie können aber auch in mehr oder weniger tranparente Kunststoffe und Harze eingebettet werden, die für Extrusionsoder Spritzgußteile verwendet werden. Diese organischen Stoffe weisen typisch Brechungsindices von n=1.4 bis 1.6 auf.

Die Reflexion eines transparenten Material mit einem Brechnungsindex von n1, welches in ein Medium mit einem Brechnungsindex n2 eingebettet ist, beträgt

$$J_r = (n1- n2)^2 / (n1+n2)^2 \qquad \text{Gl. 1}$$

Beispiel:

Für n1 = 2.4, wenn die äußere Plättchenschicht aus $TiO_2$ besteht und die Plättchen sich in einem Lack mit n2=1.5 befinden, ergibt sich eine Reflexion von $J_r$=0.053 oder 5,3% bei senkrechten Lichteinfall. Die Amplituden unterscheiden sich wie 0.053 zu 0.88x(1-0.053 ) oder wie 1:15,7. Hierbei wurde rechnerisch als Reflektor Aluminium eingesetzt mit einer Reflexion von 88%. Wäre das Einbettmedium Luft mit n2=1, wie bei fast allen Fällen von optischen Oberfllächenbeschichtungen, dann wären bei einer Schicht von n1=2.4 fast ideale Verhältnisse erreicht. Die Reflexion läge nach obiger Gleichung bei 49.8 % an der Grenzfläche Luft-Oxid und bei 0.88 x 49.8% = 43.8 % an der Grenzfläche Oxid-Aluminiumreflektor. Die Amplituden wären annähernd gleich. Bei senkrechtem Lichteinfall, der hier behandelt ist, werden die *Fresnelschen Koeffizienten* für die beiden Schwingungsrichtungen numerisch gleich, die Unterscheidung zwischen senkrechter und paralleler Lichtvektorkomponente kann unberücksichtigt bleiben. Bei schrägen Lichteinfall sind diese Komponenten unterschiedlich groß.

Um eine Amplitudengleichheit und damit die maximale Farbintensität zu erzeugen, wäre rechnerisch bei Verwendung von Aluminium mit R=0.88 als Reflektor eine Reflexion an der Grenzfläche Oxid-Lack notwendig nach Gl. 2:

$$R_{(Oxid \rightarrow Lack)} = R' = 0.88(1 - R') = R_{(Reflektor \rightarrow Oxid)}$$

$$\rightarrow R' = 0.468 \qquad\qquad Gl. 2$$

Wird Amplitudengleichheit beider reflektierten Wellen gefordert, ändern sich die rechnerischen Anforderungen an den Brechungsindex der Oxidschicht wesentlich, wenn die Schichten, aus denen die Plättchenpigmente bestehen, in einem Medium mit einem Brechungsindex von n2=1.5 eingebettet sind. Dies zeigt das folgende Rechenbeispiel.

Gl. 2 in Gl. 1 eingesetzt:

$$0.468 = (n1 - 1.5)^2 / (n1 + 1.5)^2$$

$$\rightarrow n1 = 8.28 \qquad\qquad Gl. 1a$$

Bezeichnungen zu Gleichung 1 und 2:

$J_r$ :    Reflexionsanteil Grenzfläche Oxidschicht - Lack = R'
R :    Reflexionsanteil Grenzfläche Metallschicht (Reflektor) - Oxidschicht
n1 :    Brechungsindex Oxidschicht
n2 :    Brechungsindex Lackschicht

Transparente Materialien mit einem derart hohen Brechnungsindex existieren jedoch nicht.

Die Situation würde etwas günstiger, wenn statt dem mit 88% reflektierenden Aluminium, zum Beispiel Nickel mit R = 0.40 verwendet wird. Der Wert von n1 wäre dann n1 = 5.40. Auch hier bestünde immer noch dasselbe Problem. Die Amplitude der die Oxidschicht hin und zurück durchquerenden Welle muß passend in dieser Oxidschicht vermindert werden und nicht durch Verwendung eines Reflektors mit einem sehr geringen Reflexionsanteils R. Es würde dadurch zwar auch Amplitudengleichheit erzielt werden, aber bei einem sehr niedrigen Niveau von A2 und A3 nach Fig. 2, Fall 2. Das Ergebnis wären extrem dunkle Farben ohne Verwendungsmöglichkeiten für Effektpigmente.

Um trotzdem nicht auf das Prinzip eines doppelseitigen, 5-schichtigen Fabry-Perot-Filters zurückgreifen zu müssen, wird erfindungsgemäß in die Mischschicht 1 bereits bei der Aufdampfung ein lichtabsorbierendes Material eingebaut, welches sich bei der nachfolgenden oxidativ-thermischen Behandlung an Luft nicht oder nur wenig verändert. Die beim Fabry-Perot doppelseitigen Filter erforderlichen außenliegenden halb-lichtdurchlässigen Metallschichten entfallen, nur drei Schichten sind insgesamt notwenig.

**Fig. 2** zeigt zwei Fallbeispiele: Im Fall 1 ist die Schicht 1 vollkommen transparent. Für die Skalarwerte der Amplituden gilt: A1 = A2 + A3. Es besteht eine Ungleichheit zwischen A 2 und A3. Die Intensität der reflektierten Farbe ist geringer als die im Fall 2, in dem beide Amplituden A2 und A3 gleich sind. Hier ist A1 > (A2 + A3). Die Amplitude A3 wurde durch das in die Mischschicht 1 eingebaute absorbierende Material soweit geschwächt, daß A2 = A3 wird.

Durch Variation des Anteils an absorbierendem Material in der Mischschicht 1 ergibt sich ein Werkzeug, mit dem die Farbintensität und damit die Farbtönung verändert werden kann. Hierdurch kann die Amplitude der an der Grenzfläche Oxid-Reflektor reflektierten Welle soweit verringert werden, bis sie gleich der an der Grenzfläche Luft-Oxid reflektierten Welle ist. Jede Zwischenstufe ist möglich. Die größte Farbintensität wird erzielt, wenn beide Amplituden des reflektieren Lichtes, A2 und A3, gleich sind. Um den Lackpigmenten die notwendige Langzeitstabilität von Farbe und Farbintensität und Farbtönung zu geben, muß die gesamte Mischschicht 1, die aus einer transparenten, hochbrechenden Matrix und Einschlüssen aus einem thermisch stabilen, absorbierenden Material besteht, korrosionsfest sein. Obwohl das Absorbermaterial in der Oxid-Matrix, nach **Fig 2,** Fall 2, aus der die Mischschicht 1 besteht, Veränderungen durch Luftsauerstoff nicht direkt ausgesetzt ist, ist es notwendig, daß dieses eingebettete Material auch bei der in dem nachfolgenden Prozess vorkommenden oxidativ-thermischen Behandlung noch bei mindestens 200°C seine absorbierende Eigenschaft behält. Dies ist die Temperatur, die notwendig ist, um die vollkommene Oxidation des Matrixmaterials in technisch vertretbaren Zeiten zu erreichen. Gleichzeitig stellt diese oxidativ-thermische Behandlung eine zeitgeraffte Alterung des Pigments dar. Bei der späteren Verwendung in einem Karosserielack kommen Temperaturen in dieser Höhe nicht mehr vor. Die Metalle Chrom, Nickel, Eisen, Vanadium, Molybdän und nur wenige andere verändern sich bei der Oxidation der Matrix bis 200°C nicht oder nur wenig, die Metalle Titan und Zirkonium erfüllen diese Bedingung nur bis etwa 120°C.

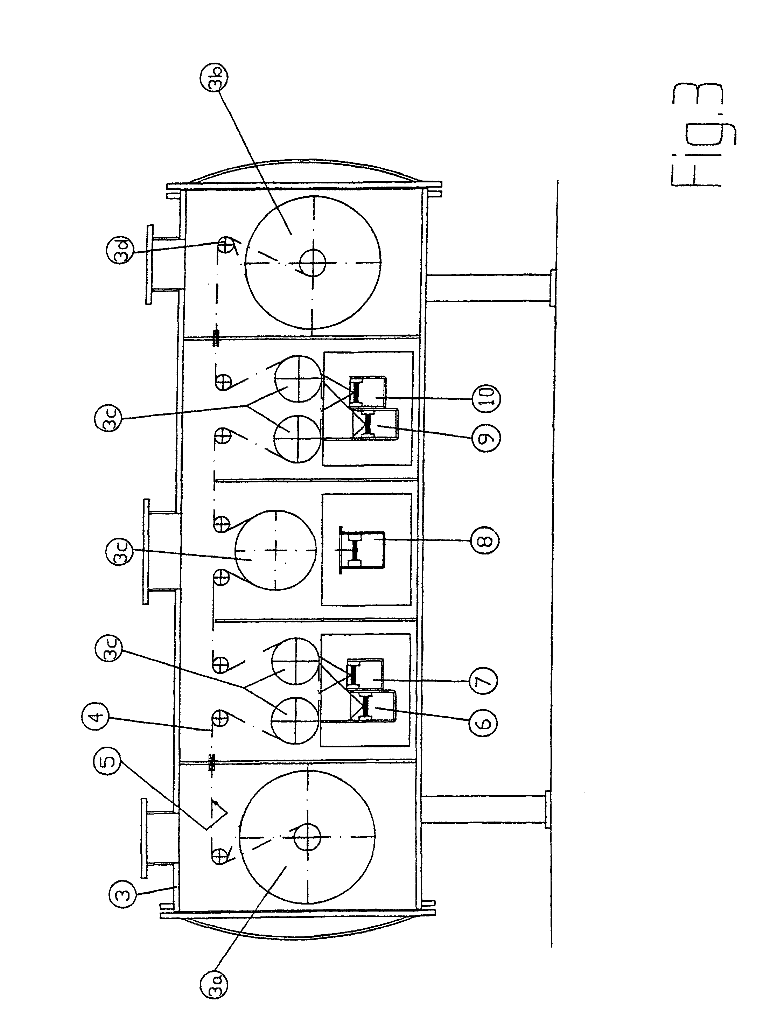

Im folgenden wird anhand von Fig. 3 eine Vorrichtung zur Erzeugung von farbigen Pigmentplättchen erläutert.

Demgemäß wird in einer kontinuierlich auf $10^{-1}$ bis $10^{-3}$ Pascal gepumpten Vakuumkammer 3, die einen Abwickler 3a, einen Aufwickler 3b und eine Anzahl dazwischenliegender Kühlwalzen 3c und Umlenkwalzen 3d bekannter Bauart enthält, ein bandförmiges Trägermaterial 4, welches mit einem leicht löslichen Trennmittel 5 vorbeschichtet ist, in einem Durchlauf am Verdampfer I 6 mit einem Material aus der Gruppe der Titansuboxide, Zirkonmonoxid, Nioboxid mit einer Schichtdicke bedampft wird, die im Bereich einer optischen Dicke n x d = $\lambda$/4 bis 3$\lambda$/4 liegt.

Ein weiteres, für eine Hochgeschwindigkeit-Verdampfung gut geeignetes Material ist Cer-Metall, aus Kostengründen wird handelsüblichem Cer-Mischmetall, welches ein Gemisch verschiedener Lanthaniden darstellt, der Vorzug gegeben. Auch dieses Material gibt nach einer nachfolgenden oxidativ-thermischen Behandlung an Luft ein Oxid, $CeO_2$, mit einem Brechungsindex von n=2.0 Nachteilig sind die pyrophoren Eigenschaften dieses Metalls, die besondere Vorsichtsmaßnahmen erfordern beim und nach dem Öffnen der Vakuumkammer. Der Arbeitsdruck bei der Verdampfung aller Substanzen beträgt typisch $3 \times 10^{-2}$ Pa. Dieser Druck ist ein Kompromiß zwischen der notwendigen Mittleren Freien Weglänge und dem Aufwand an installierter Pumpkapazität der Anlage.

Wegen der hohen notwendigen Verdampfungstemperaturen der Oxide eignen sich am besten Elektronenstrahlverdampfer verschiedener, bekannter Bauarten oder induktiv beheizte Graphittiegel. Hierbei erweist sich die gute elektrische Leitfähigkeit, auch im nicht geschmolzenen Zustand einiger weniger Sub-Oxide, wie z.B. TiO als sehr günstig. Da die Plättchen-Pigmenterzeugung ein Langzeitprozeß ist, welcher über viele Stunden unterbrechungsfrei ablaufen soll, ist es notwendig, Verdampfungsmaterial kontinuierlich genau dosiert zuzuführen. Entsprechende Einrichtungen, wie kommerziell erhältliche Schwingförderer, Schneckenförderer erfüllen diese Aufgabe nach gewissen Änderungen, die der Betrieb unter Vakuum und bei intensiver Wärmestrahlung erfordert.

Durch einen weiteren Verdampfer Ia 7, dessen Dampfkegel sich mit dem des Verdampfers I 6 überlappt, wird ein absorbierendes Material in Anteilen zwischen 1 bis 50 Mol % der Mischschicht 1 zugemischt.

Als absorbierende Materialien eignen sich Stoffe wie Chrom, Nickel, Eisen, Kobalt, Vanadium, Molybdän, aber auch Legierungen, welche diese Metalle enthalten. Die Verdampfung von Legierungen erfolgt zweckmäßig aus getrennten Quellen unter Einhaltung des benötigten Molverhältnis.

Die Verwendung eigener Verdampfer für das absorbierende Material ist nicht immer notwendig. Es besteht die Möglichkeit, sogenannte Springstrahl-Elektronstrahlverdampfer bekannter Bauart zu verwenden, bei welcher der Strahl zwischen zwei eng beieinanderliegenden Tiegeln schell hin- und herspringt. Das Verhältnis der Verweilzeiten in den einzelnen Tiegeln kann variiert werden. Damit läßt sich das Molverhältnis der Verdampfung von zwei Substanzen bequem einstellen und über lange Zeiträume konstant halten.

Eine direkte Zugabe des lichtabsorbierenden Materials zum Oxid-bildenden Verdampfungsmaterial ist nur in wenigen Fällen möglich, da Dampfdruckunterschiede beider Stoffe in einem kontinuierlichen Verdampfungsverfahren nach kurzer Zeit das Molverhältnis im Kondensat und in der Verdampferquelle ändern. Die Komponente mit dem niedrigeren Dampfdruck reichert sich im Tiegel an. Farbtonveränderungen des Produktes über der Zeit wären die Folge.

In Bandlaufrichtung folgt der Verdampfer II 8, der die Reflexionsschicht aufträgt. Diese besteht immer aus einem Metall, wie Aluminium, Silber, Chrom, Zirkonium, Niob, Molybdän, Vanadium, Titan oder aus Legierungen wie Chrom-Nickel, Eisen-Nickel, Eisen-Chrom, Nickel-Kobalt und andere, wenn sie gleichzeitig im zeitlich konstanten Molverhältnis aus getrennten Quellen verdampft werden. Das Magnetron-Sputterverfahren ist aus wirtschaftlichen Gründen für die Herstellung dieses Produktes zu langsam. Die an diese Metalle gestellte Anforderung ist eine Schichtdicke, die ausreichend ist, um eine geringe Lichtdurchlässigkeit von T < 1% zu erzeugen. Dies entspricht einer optischen Dicke von OD > 2. Die Verwendung von Metallen, die weniger reflektierend sind als Aluminium oder Silber, erlauben es, um Amplitudengleichheit zu erzielen, den Anteil an absorbierenden Material in der Mischschicht 1 zu verringern.

Varianten, bei denen absichtlich die Lichtdurchlässigkeit der Reflexionsschicht bis auf T = 50% erhöht wird, erzeugen Pigment-Plättchen mit gedämpften Farben, welche ein perlmuttähnliches Aussehen haben. Sie eignen sich als Zumischungs-Pigment bei der Lackerzeugung, um Sondereffekte zu erzielen. Um sehr dunkle Farbtöne zu produzieren, kann der Anteil an lichtabsorbierendem Material in der Mischschicht 1 erhöht werden in Verbindung mit einem Reflektor 2 aus Cr, oder Ni, Fe, Co .

In Bahnlaufrichtung des bandförmigen Trägermaterials 4 folgt der Verdampfer III 9 und der Verdampfer IIIa 10. Sie produzieren die Mischschicht 1, die in ihrer Dicke und dem Molverhältnis dem der durch die Verdampfer I 6 und Ia 7 erzeugten Schicht entsprechen soll.

Die kontinuierliche Kontrolle der aus allen 5 Quellen stammenden Schichtdicken ist notwendig zur Erzeugung und Wiederholung der genau gleichen Farben. Zahlreiche Meßmethoden hierzu sind in der Literatur beschrieben und können eingesetzt werden, wie z.B. die Draht/Lasermethode nach DE 4338907 A1 oder die Draht/CCD Kamera-Methode nach DD 269660 A1 und weitere bekannte, kommerziell erhältliche Geräte, die auf dem Ionisationsprinzip des Dampfes mit Messung der Intensität einer ausgewählten Spektrallinie beruhen oder nach dem Schwingquarzprinzip mit vorgeschalteter, getakteter Blende arbeiten. Diese Taktmessung mit einem großem Zu- zu Auf- Verhältnis der Blende streckt die Nutzungsdauer eines Schwingquarzes bevor dessen Sättigung eintritt.

Nach dem Aufbringen der drei Schichten wird das bandförmige Trägermaterial 4 an einer Aufwickelstation 3b wieder aufgerollt. Die Vakuumkammer 3 wird belüftet, die bedampfte Rolle wird entnommen.

Als sehr wirtschaftliche Variante kann in einer besonders für diesen Zweck konstruierten Anlage ein geschlossenes Metallband über Rollenschleusen nach der Bedampfung an die Atmosphäre geführt werden, das Produkt dort abgelöst werden und nach erneuter Beschichtung mit einem Trennmittel wieder an den Verdampfern vorbeigeführt werden.

An das Trägerband sind hohe Anforderungen bezüglich der thermischen Belastbarkeit gestellt. Gegenüber dem Auftrag einer 40 Nanometer dicken Aluminiumschicht bei ca. 1450°C Verdampfertemperatur beim klassischen Bedampfen von Kunststoff-Folien beträgt die Verdampfungstemperatur bei Oxiden typisch 2200 bis 2300°C und die Dicke des 3-Schichtenpaketes beträgt etwa 1000 Nanometer. Die eingebrachte thermische Energie aus Kondensation und Strahlung steigt bis zum 50-fachen. Die Verwendung eines Metallbandes ist vorteilhaft sowie der Einbau einer genügend großen Zahl von Kühlwalzen 3c zwischen den Verdampferstationen.

**Tabelle 1** die bei einem Versuch gewonnenen Prozeßdaten bei Verwendung von Titanmonoxid als Verdampfungsmaterial, welches mittels eines Elektronenstrahlverdampfers bei kontinuierlicher Materialzufuhr bei einer Badtemperatur von 2250°C verdampft wurde. Die Temperaturmessung erfolgte pyrometrisch nach einer entsprechenden Eichung. Die Beimischung von 5 Mol-% Chrom erfolgte aus einem Temperatur-geregelten, widerstandsbeheizten Verdampfer. Der Dampfkegel des Chroms vermischte sich mit dem des Titan-Monoxids bei einem konstanten Molverhältnis beider Stoffe. Als Trägerband wurde in einem Abstand von 150 mm ein 150 mm breites, 0.4 mm dickes Stahlband beschichtet, welches freigespannt zwischen einem Ab- und einem Aufwickler über der Verdampfungsquelle vorbeigeführt wurde. Die Temperaturzunahme des Bandes betrug unter den in der Tabelle 1 angeführten Bedingungen bei der Bedampfung mit nur einer TiO-Schicht +80 °C.

Tabelle 1

| Vakuum (*) | $3 \times 10^{-2}$ bis $4 \times 10^{-3}$ Pa |
|---|---|
| Bandgeschwindigkeit | 194 m/min |
| Verdampferleistung | 24.8 kW bei 10 kV |
| zugeführte Menge an TiO | 50 g/min ( = verdampfte Menge) |
| am Band niedergeschlagene Menge | 42 g/min ( = ca. 10 $cm^3$/min.) |
| Tiegelfläche | 9 $cm^2$ |
| erreichte Schichtdicke (**) | 340 Nanometer |
| optische Dicke n x d ( gerechnet) (***) | 816 Nanometer |
| Verdampfungsgeschwindigkeit bei 2250°C | 0,10 g $sec^{-1}$ $cm^{-2}$ |
| Abstrahlung des 9 $cm^2$ Tiegels bei 2250°C (****) | 7.9 kW ($\varepsilon$= 0.5) |
| Verdampfungswärme bei 50 g/min. TiO | 9.6 kW (rechnerisch) |
| Wärme an Kühlwasser des Verdampfers | 2.8 kW ( gemessen ) |
| Energieeinsatz pro kg kondensiertem TiO | 9,84 kWh |

(*): Da TiO eine starke Getterwirkung zeigte, änderte sich das Vakuum während der Betriebszeit des Verdampfers in Richtung auf den niedrigeren Druck.

(**) Durch nachträgliche Wägung von abgelöstem Kondensat bestimmt und ausgewertet. Der Schichtdickenabfall zum Rand des Trägers hin folgte annähernd dem $cos^3\Phi$ - Gesetz außerhalb eines Bereich konstanter Dicke von +/- 35 mm von der Mittellinie des Trägers gemessen.

(***): Für n = 2.4; dieser Wert wird erhalten nach erfolgter Oxidation der Schicht an Luft zu $TiO_2$. Die TiO- Schicht nach der Bedampfung ist grau.

(****): Ermittelt durch kalorimetrische Messung mittels einer wassergekühlten Haube über dem Verdampfer bei einem Vorversuch bei gleicher, pyrometrisch gemessener Tiegeltemperatur, gemessen an einem Molybdänblock gleicher Größe.

Diese Anordnung erlaubte die Trennung von Strahlungs- und Kondensationswärme, da Molybdän bei dieser Temperatur eine Verdampfungsgeschwindigkeit von nur $1 \times 10^{-5}$ g/$s^{-1}$ $cm^{-2}$ hat.

Dieser Versuch, welcher prüfen sollte am Beispiel von Titan- Monoxid ( TiO ), ob sich ein industrieller Prozess unter wirtschaftlichen Bedingungen verwirklichen läßt, zeigte :

- Bahngeschwindigkeiten von 200 m/min und mehr sind möglich, selbst bei einer Beschichtungsdicke von nd = 3λ /4 für λ = 700 Nanometer.

- Ein Energieeinsatz an Verdampferleistung von ca. 10 kWh pro kg aufgedampftes Titan-Monoxid ist wirtschaftlich vertretbar

- Technische Mengen von 50 jato sind im 5000-Stundenbetrieb bei 100 kW Verdampferleistung für die 2 Mischschichten 1, ca. 20 kW für die Reflektor-schicht 2 und ca. 20 kW für das absorbierende Verdampfermaterial in den beiden Mischschichten 1 herstellbar. Der gesamte Energiebedarf zur Aufdampfung aller drei Schichten 1, 2 und 1 nach **Fig. 2** beträgt demnach ca. 14 kWh pro kg des erzeugten Plättchen-Pigmentes. Der Energiebedarf für die oxidativ-thermische Behandlung liegt bei ca. 0.7 kWh pro kg. Die Kosten der Weiterverarbeitung durch Mahlen, Größenklassifizieren und Vermischen mit Lack sind die gleichen wie bei den bekannten erwähnten Produkten.

Nach der Aufdampfung auf den bandförmigen Träger 4 wird nach bekannter Technik in einer separaten Ablösestation das Trennmittel 5 in einem Lösungsmittelbad im Durchlauf entfernt. Die aufgedampfte Schicht zerfällt hierbei in Flocken, welche in einem weiteren Prozeß von den Lösungsmittelresten befreit und getrocknet werden und durch Mahlen nach bekannten Methoden auf die gewünschte Teilchengröße der Pigmentplättchen zerkleinert werden.

Als nächster Schritt erfolgt die oxidativ-thermische Behandlung der Plättchen in einem Heißluft-durchströmten Haufwerk bei vorzugsweise 200 bis 300°C, um die durch den Aufdampfvorgang mit hoher Auftragsgeschwindigkeit erzeugten Schichten, je nach verwendetem Material zu $TiO_2$, $ZrO_2$, $CeO_2$ weiter zu oxidieren. Statt Heißluft können auch andere sauerstoffhaltige Gasgemische verwendet werden. Da es sich bei dieser Oxidation um einen leicht exothermen Vorgang bei großer Oberfläche handelt, wird die Sauerstoff- oder Luftmenge kontrolliert. Die Behandlungszeiten sind temperatur- und schichtdickenabhängig und liegen bei 5 bis 10 Minuten.

In einem folgenden Arbeitsgang können unerwünscht kleine oder noch zu große Partikel durch Windsichten oder durch Sedimentation nach bekannter Art abgetrennt werden. Es werden für die meisten Lackanwendungen Partikelgrößen von 5 bis 12 μ angestrebt. Nach diesen Schritten durchlaufen die Plättchenpigmente die in der Lack- oder Druckfarbenherstellung bekannten Schritte beim Verarbeiter.

**Fig. 4** zeigt qualitativ, welche optischen Variationsmöglichkeiten bei der Erzeugung des hier beschriebenen 3-Schichtsystems durch in die Schichten 1 und 2 eingebauten absorbierenden Materialien bestehen. Die hier dargestellten Kurvenscharen beruhen auf folgenden Variablen:

a) Schichtdicke der Mischschicht 1: Sie bestimmt die Wellenlänge des Reflexionsmaximums. **Fig. 4** zeigt eine Wellenlänge von λ=550 Nanometer. Andere Schichtdicken von nd=zλ/4 mit 1<z<3 verschieben die Maxima der Kurvenschar zu kleineren oder größeren Wellenlängen, wobei sich mit zunehmender Zahl z das Farbenspiel wiederholt und an Farbfülle zunimmt.
b) Zumischungsmenge in Molprozent an absorbierendem Material
c) Hoch- oder niedrigreflektierende Reflexionsschicht 2.

Die Kurven 1 bis 5 nach **Fig. 4** beruhen auf einem hoch reflektierenden Reflektor aus Aluminium. Der Anteil an absorbierendem Material steigt mit den Zahlen von 1 bis 5. Die Bedingung der Amplitudengleichheit ist erreicht bei Nr. 5. Dann liegt die intensivste Farbe vor und im Bereich von 550 +/- 100 Nanometer ist die Steilheit der Kurve dR/dλ am größten. Das Erscheinungsbild der Kurve 1 ist hell und von geringer Farbfülle. Würde der Anteil an absorbierenden Material in der Mischschicht 1 nach **Fig. 2** noch weiter erhöht werden, gehen die Kurven in Richtung 4 bis 1 zurück, wobei das Maximum der Kurven in Richtung auf das der Kurven 10 bis 13 darunter geht. Das optische Bild der Reflexion ändert sich allerdings in Richtung auf ein metallisches Aussehen.

Die Kurven 10 bis 13 zeigen dasselbe Verhalten bei einem niedrig reflektierenden Reflektor 2, welcher hier aus Chromnickel 60/40 besteht. Auch hier wird eine Amplitudengleichheit bei Kurve Nr. 13 erreicht. Eine weitere Erhöhung des Gehalts an absorbierenden Material in der Schicht 1 nach **Fig 2** verringert sich die Farbintensität wieder. Nicht in jedem Falle ist bei Effektpigmenten in Lacken maximale Farbintensität erwünscht, so daß Abweichungen von den Kurven Nr. 5 und 13 nach **Fig. 4** durchaus von Interesse sind. Da die Wellenlänge des Reflexionsmaximums abhängig von der optischen Dicke n x d der Mischschicht 1 ist, ergeben sich notwendigerweise zur Erzielung maximaler Farbintensitäten unterschiedliche Molanteile an absorbierendem Material, um eine Gleichheit der Amplituden A2 und A3 nach **Fig 2** zu erzielen. Die Zusammenhänge können wegen ihrer Vielseitigkeit nur qualitativ an einem Beispiel angegeben werden, da die Kombination nach Tabelle 2 aus verschiedenen Schichtdicken, hochbrechenden und absorbierenden Materialien, deren Molverhältnis und das verwendete Reflektormaterial der Schicht 2 eine Vielzahl vom menschlichen Auge unterscheidbare Farbvarianten ermöglichen. Diese Zahl läßt sich abschätzen zu:

| GruppeA | B | C | C |
|---|---|---|---|
| unterscheidbare Farben im Bereich von 450 bis 700nm Wellenlänge in Stufen von 10nm    x | Schichtdickenbereich $nd=\lambda/4$ (450nm<λ <700nm)   x $nd=2\lambda/4$ $nd=3\lambda/4$ | verschiedene Reflektoren Al:88%Reflexion Ni:40%   x Cr:32% | verschiedene Molprozente Absorbermat. in Oxidschicht = 1350 |
| 25 | 3 | 3 | 6 |

**Tabelle 2**

Der Experimentator wird deshalb zuerst nach Tabelle 2 aus den Gruppen A und B die gewünschte Farbe nach der Wellenlänge festlegen und dann die 16 Varianten aus den Gruppen C und D so zusammenstellen, bis der gewünschte Ton vorliegt. Diesen kann er nochmals verändern durch Mischen der Plättchenpigmente mit solchen, die allein aus einem Metall der Gruppe C hergestellt sind.

Das so erzielte Produkt zeichnet sich neben den aufgeführten Eigenschaften auch durch seine sehr gute chemische Beständigkeit aus, da die Pigmentoberfläche, je nach dem angewandten Verfahren, aus $TiO_2$, oder $CeO_2$, $Nb_2O_5$, Zr02 besteht und nicht aus einer Metallschicht. Die Reihenfolge der chemischen Beständigkeit gegen die meisten Säuren, mit Ausnahme von Flußsäure nimmt zu in der Reihenfolge $CeO_2 \rightarrow Nb_2O_5 \rightarrow TiO_2 \rightarrow ZrO_2$. Der Angriff der metallischen Reflektorschicht an den Bruchkanten kann vernachlässigt werden, da die Reflektordicke von 50 Nanometern klein ist zum Verhältnis der Plättchen- Dimension von typisch 10.000 Nanometern. Das entstehende feste Reaktionsprodukt blockiert an den Kanten unter den vorliegenden geometrischen Bedingungen das Weiterschreiten der Korrosion. Es bestehen bekannte Methoden, um die Metalloder Reflexionsschicht 2 an den Bruchstellen der Pigmentplättchen zu passivieren, z. B. durch eine Chromatisierung in einem Folgeschritt, wenn die Reflexionsschicht 2 aus Aluminium besteht.

Die Plättchen weisen, je nach dem verwendeten Oxid, Dichten von $\rho$ = 2.5 bis 3.5 $g/cm^3$ auf. Sie orientieren sich beim Lackieren planparallel zum Untergrund. Etwa 4g des Plättchen-Pigmentes pro Quadratmeter lackierter Fläche geben bereits eine 1.8-fache optische Überdeckung des Hintergrundes.

Gegenüber den in dieser Schrift beschriebenen bekannten Verfahren, welche Magnesiumfluorid als transparente Schicht verwenden, ergibt sich als weiterer Vorteil eine wesentlich geringere benötigte Menge an hochbrechendem Oxid pro Flächeneinheit: Die optisch wirksame Dicke ist definiert als n x d. Das Brechungsindex-Verhältnis zwischen $MgF_2$ und $TiO_2$ ist 1.38/2.40=0.575. Wenn Titan-Monoxid (TiO) als Ausgangsmaterial verwendet wird, liefert die oxidativ- thermische Behandlung durch Sauerstoffaufnahme nochmals einen Faktor $M_{TiO}/M_{TiO2}$=0,8. Beide Faktoren ergeben unter Berücksichtigung der unterschiedlichen Dichten einen um 38% kleineren Verbrauch an verdampftem TiO gegenüber Magnesiumfluorid. Der durch die Oxidation von TiO zu $TiO_2$ entstehende Massenzuwachs verursacht keine Materialkosten, da er auf der Aufnahme von Sauerstoff aus der Luft bei der nachfolgenden oxidativ-thermischen Behandlung beruht. Ferner entfällt die bei MgF2 notwendige, etwa 8 Nanometer dicke Chrom- Außenschicht auf beiden Seiten.

Mögliche apparative und verfahrenstechnische Varianten bei der Herstellung von Plättchen-Pigmenten nach dieser Erfindung sind:

- Verwendung eines Metallbandes; dieses erlaubt, die hohe Kondensationswärme und die von den Verdampfern ausgehende Strahlungswärme ohne thermische Schädigung aufzunehmen. Es können ohne Zwischenkühlung an Walzen alle drei Schichten 1-2-1 nach **Fig. 2** aufgebracht werden.
- Verwendung eines geschlossen umlaufenden Metallbandes über dynamische mehrstufige Luft-zu-Luft-Schleusen bekannter Bauarten. Die Schritte der Trennmittelbeschichtung-Bedampfung-Ablösung des Produktes erfolgen hierbei nacheinander. Die Ablösung des Produktes erfolgt hierbei vorzugsweise bei Atmosphärendruck.
- Die Trennmittelschicht 5 kann eine im selben Vakuumprozeß aufgedampfte Schicht sein im Dickenbereich von 5 bis 1000 Nanometer, die aus einem im Vakuum verdampfbaren Salz der Gruppe der Chloride, Fluoride, Borate besteht.

- Herstellung eines nur einseitigen Pigmentes. Die Rückseite erscheint dadurch metallisch neutral und liefert durch die beliebige Seitenlage der Plättchen im Lack Farbtönungen einer neuen Variante. Die typische Teilchengröße von 5 bis 20 μ läßt Einzelpartikel mit dem bloßen Auge noch nicht in Erscheinung treten.
- Herstellung eines asymmetrischen Plättchenpigments, bei welchem sich die Schichtdicken der Mischschichten 1 aus beiden Seiten der Reflexionsschicht 2 unterscheiden und damit die Wellenlänge der maximalen Reflexion. Im Produkt entsteht dadurch eine Mischfarbe.

Die Erfindung erlaubt es, für die Lack- und Druckfarbenindustrie neue Effektpigmente in einer sehr großen Farbpalette herzustellen, indem in einem einzigen Verfahren nur zwei Parameter während des Prozesses variiert werden müssen. Dies ist die Auftragungsgeschwindigkeit eines transparenten Materials (Oxidmaterial) und die eines lichtabsorbierdenden Materials. Die Wahl eines Reflexionsmaterials bestimmt die Helligkeit des Grundtons der Farbe. Die Umstellung von einem Farbton auf einen anderen kann deshalb fast verzögerungsfrei ohne apparative Veränderung und ohne Materialwechsel erfolgen. Das Herstellverfahren nach dieser Erfindung benutzt nur ungiftige Feststoffe innerhalb einer geschlossenen Vakuumapparatur.

Offenbart sind entsprechend dem ersten Ausführungsbeispiel der Erfindung ein Verfahren und eine Vorrichtung zur Herstellung von Farbpigmenten, durch die auf eine Reflexionsschicht zumindest eine Mischschicht aus einem transparenten Material und einem lichtabsorbierenden Material aufgebracht wird.

Zweites Ausführungsbeispiel

Das anorganische Farbpigment entsprechend einer ersten Abwandlung des zweiten Ausführungsbeispiels der vorliegenden Erfindung besteht aus planparallen Plättchen mit großer Farbfülle auf der Basis von $TiO_2$-$SiO_2$-Schichten oder von anderen, transparenten, hoch- und niedrigbrechenden Schichten, welche in einem PVD-Verfahren hergestellt werden. Die Farben entstehen durch Interferenz an der Grenzschicht der Luft zur hochbrechenden Schicht und am Übergang zwischen der ihr folgenden niedrigbrechenden und hochbrechenden Schicht. Zur Erzeugung einer hohen Farbfülle wird während des PVD-Prozesses entsprechend der vorliegenden Erfindung in die durch Verdampfung eines Suboxides des Titans erzeugte hochbrechende Schicht durch Dampfmischung ein Metall, wie Cr, Ni, Co, Fe. Nb, V, in einem Verhältnis von 1-50% Molprozenten zugemischt. Das Metall kann aber auch eine intermetallische Verbindung sein, so z.B. ein Silicid wie TiSix. Die Erzeugung der vorzugsweise verwendeten $SiO_2$-Schicht oder -Schichten erfolgt durch Verdampfung eines anorganischen Silizium-haltigen Materials, vorzugsweise Siliziummonoxid. Das Schichtpaket wird nach dem Ablösen vom Träger, auf welchem es erzeugt wird, durch Tempern an Luft bei 150 bis 500°C weiter zu $TiO_2$ und $SiO_2$ oxidiert, wobei die Temperatur so gewählt wird, daß noch keine Oxidation des zugemischten Metalls auftritt.

Zur Herstellung des anorganischen Farbpigmentes entsprechend der ersten Abwandlung des zweiten Ausführungsbeispiels der Erfindung, welches nur aus einer Anordnung von hoch- und niedrigbrechenden Schichten besteht, eignet sich vorzugsweise Titandioxid als hochbrechendes Oxid mit einem Brechungsindex von etwa n=2,4. Die Schichten werden durch thermische Verdampfung von Titanmonoxid (TiO) erzeugt. Als niedrigbrechendes Material eignet sich Siliziumdioxid, welches durch Verdampfen von Silizium- Monoxid auf bekannte Weise erzeugt wird. In beiden Fällen ist es erforderlich, das so erzeugte Produkt, nachdem es von seinem Träger abgelöst worden ist, in oxidierender Atmosphäre bei 150 bis 600°C, vorzugsweise bei 200 bis 300°C, zu tempern. Diese Temperung führt bei der Reaktion TiO + ½ O2 → $TiO_2$ zu einer Gewichtszunahme durch Luftsauerstoff von 25%, ohne daß wesentliche zusätzliche Kosten entstehen.

Oxidschichten mit fast stöchiometrischem Sauerstoffanteil entsprechend der höchsten Oxidationsstufe lassen sich zwar auch durch eine sogenannte reaktive Verdampfung entsprechend bekannten Verfahrensweisen bei Anwesenheit von Sauerstoff erzielen, wie es beispielsweise in der US2,920,002 beschrieben ist, doch sind die möglichen Aufdampfgeschwindigkeiten bei reaktiver Verdampfung gering; sie erlauben nicht die Herstellung von stündlichen Mengen von 5 bis 10 Kilogramm aus einem Verdampfer. Eine typische Verweilzeit in der Verdampfungszone für eine 200 Nanometer dicke Schicht beträgt bei einer wirtschaftlichen Bandgeschwindigkeit des Substrates von 200m/min nur etwa 0,1 Sekunden. Der Schichtaufbau beträgt demnach etwa 2000 Nanometer/Sekunde. Reaktive Verdampfungen, die bei etwa 2 bis 5x10$^{-4}$mbar stattfinden, lassen höchstens einen Schichtaufbau von 2 bis 5 Nanometer pro Sekunde zu.

Sowohl theoretische Überlegungen wie auch deren experimentelle Bestätigung haben gezeigt, daß sich durch das Einbringen von Metalldampf von Chrom, Eisen, Nickel, Molybdän, Kobalt, Niob, Vandadium in Molanteilen von 1 bis 50% in hochbrechende, transparente Schichten eine breite Palette an Farben und Farbtönungen erzeugen läßt. Je kleiner der Anteil des Metalls, desto pastellartiger und blasser erscheinen die Farben. Bei hohen Metallanteilen entstehen dunkle, fast farbneutrale, metallische Tönungen.

Mit einem Werkzeug, mit dem die Schichtdicke und der Metallanteil variiebar ist, können in einem einzigen Durchlauf alle Schichten aufgetragen werden, wobei durch Wahl der Dicke der mittleren niedrigbrechenden Schicht im Bereich einer optischen Dicke nxd von 100 bis 600 Nanometer die Farbe bestimmt wird.

Die Durchführung der Ablösung der Produktschichten von Träger entsprechend der ersten Abwandlung des zweiten Ausführungsbeispiels der vorliegenden Erfindung erfolgt nach bekannter Art, wobei der Träger vorzugweise ein Metallband ist und das Trennmittel eine kurz vorher, im selben Durchlauf aufgedampfte, wasserlösliche Salzschicht von etwa 50 Nanometer Dicke ist. Eine zur Erzeugung derartiger planpareller Plättchen besonders geeignete Apparatur ist von H. Weinert in "Proceedings of the 13th International Conference on Web Coatings, 17.-18.10.1999, Tucson-Arizona/U.S.A.) und in der Veröffentlichung unter www.weinert-vac.de/publications/particles.htm beschrieben.

Die Erfindung bezieht sich jedoch nicht nur auf ein 3-Schichtensystem der Anordnung H-L-H, wobei H eine hochbrechende, transparente Schicht mit in der Dampfphase eingemischtem Metall der Dicke 1/4=nxd ist, wobei n der Brechnungsindex (ohne Einheit), d die geometrische Dicke (nm) und 1 die: Wellenlänge (nm) ist, L eine niedrigbrechende, transparente Schicht im Dickenbereich von nxd =70 bis 500 Nanometern ist, wobei für L dieselben Bezeichnungen wie für H gelten.

Es sind auch weitere Kombinationen möglich, wie beispielsweise H-LL-H, HH-LL-HH, H-L-H-LL-H-L-H, H-LL-H-LL-H, wobei LL hier für 1/2=nxd steht. Auch kann ein assymmetrischer Schichtaufbau vorliegen.

Nachfolgend werden weitere Abwandlungen des zweiten Ausführungsbeispiels entsprechend der vorliegenden Erfindung angegeben:

Zweite Abwandlung des zweiten Ausführungsbeispiels

Zur Herstellung eines Pigmentes aus planparallelen Plättchen wird unter Hochvakuum auf einen laufendes Band nacheinander und im selben Durchlauf aus mehreren Verdampfungsquellen aufgedampt:

- Natriumtetraborat als 50 Nanometer dicke Trennmittelschicht, entsprechend einem Flächengewicht von 0.1 g/m$^2$,
- Titanmonoxid aus einer Quelle A und Chrommetall aus einer Quelle B. Die Dampfkegel beider Quellen überschneiden sich. Die Schichtdicke der Titan-Monoxidschicht beträgt, gemessen mittels Meßmethoden bekannter Art, 150 Nanometer oder 0.75 g/m$^2$ Titanmonoxid, dem aus einer Quelle B 0.05 g/m$^2$ Chrommetall beigemischt wird,
- eine Schicht aus Siliziummonoxid mit einem Flächengewicht von 0.5 g/m$^2$,
- eine Wiederholung der gleichen Titanmonoxid-Schicht mit gleichem Chromanteil.

Nach dem auf bekannte Art erfolgten Ablösen des Schichtenverbundes durch Auflösen der Natriumtetraborat-Schicht wird das zu kleinen Flocken zerfallende Produkt gewaschen, gefiltert, getrocknet und in einem Luftofen unter Umwälzen auf 400°C erhitzt. Danach erfolgt in einem Mahlprozeß die weitere Zerkleinerung der Flocken und ihre Größenklassifizierung durch Windsichten.

Das Ergebnis dieser zweiten Abwandlung ist ein Pigment mit einer in einem transparenten, farblosen Lack tief grün aussehenden, kräftigen Farbe.

Dritte Abwandlung des zweiten Ausführungsbeispiels

Nur die Silizium-Monoxid Schicht wird in ihrem Flächengewicht um 10% erhöht. Das Ergebnis nach derselben Behandlung wie bei der zweiten Abwandlung ist ein tiefgelbes, kräftiges Pigment.

Vierte Abwandlung des zweiten Ausführungsbeispiels

Der Chromanteil der beiden Titan-Monoxidschichten wird auf 0.025 g/m$^2$ vermindert. Alle anderen Parameter entsprechen der zweiten Abwandlung. Das Ergebnis ist ein weniger kräftiges, pastellfarbenes grünes Pigment.

Fünfte Abwandlung des zweiten Ausführungsbeispiels

Entsprechend der zweiten Abwandlung wird bei sonst gleichen Parametern der Chromanteil von 0.05 g/m$^2$ auf 0.075 g/m$^2$ erhöht. Das Ergebnis ist ein dunkelgrün schimmerndes, metallisch aussehendes Pigment.

Mögliche Varianten, die dem mit optischen PVD-Beschichtungen vertrauten Fachmann bekannt sind, sind Verfahren unter Verwendung von Tantaloxid, Zirkonoxid oder Zirkonsuboxid, Ceroxid, Nioboxid, Eisenoxid (FeO, Fe$_2$O$_3$) und anderen transparenter Stoffe mit einem Brechungsindex von >1.9. Hierzu zählen auch Zinksulfid und Zinkselenid. Als mögliche Stoffe mit einem niedrigen Brechungsindex können verwendet werden: Magnesiumfluorid, Cerfluorid und andere, mit einem Brechungsindex von <1.7. Die Schichtdicken müssen hierbei nicht ganzzahlige Vielfache von nxd=1/4 sein. Die Literatur kennt Computer-gestützte Berechnungsmethoden, mit welchen die Reflexion und Transmission eines Schichtdickensystems mit großer Genauigkeit vorausberechnet werden kann.

Entsprechend einer sechsten Abwandlung des zweiten Ausführungsbeispiels der vorliegenden Erfindung kann der niedrigbrechenden Schicht ein absorbierendes Metall in ganz geringer Menge beigemischt werden. Dadurch ändert sich die Wirkung der Erfindung jedoch nicht wesentlich.

Bei allen Ausführungsbeispielen wird ein Temperverfahren an Luft durchgeführt, welches durch Aufnahme von Sauerstoff aus der Luft zu einer kostengünstigen 25%igen Gewichtszunahme führt (63,9g TiO+16g ½O2→79,9 g TiO2). Dieses ist von ökonomischen Vorteil, da Pigmente nach Gewicht und nicht nach der Oberfläche verkauft werden.

Somit unterscheidet sich der Gegenstand des zweiten Ausführungsbeispiels vom Gegenstand des ersten Ausführungsbeispiels darin, daß im ersten Ausführungsbeispiel ein Metallreflektor vorkommt, der im zweiten Ausführungsbeispiel nicht vorhanden ist. Entsprechend dem zweiten Ausführungsbeispiel bestehen die Schichten aus transparentem Material in der Abfolge H-L-H, mit allen vorstehend angegebenen Variationsmöglichkeiten. In alle H-Schichten wird ein weiteres Metall durch Vermischung in der Dampfphase eingebracht.

Beim Farbpigment entsprechend dem ersten Ausführungsbeispiel kommt nur ein Reflektor mit einer beidseitigen Titanoxidschicht, der durch Mischung im Dampfkegel ein Metall beigemischt wird, vor. Beim zweiten Ausführungsbeispiel ist statt der Reflektorschicht eine niedrigbrechende Schicht, der kein Metall beigemischt wird, vorhanden.

Die Herstellung, die Wirkungen und die Vorteile der Farbpigmente nach dem zweiten Ausführungsbeispiel entsprechen mit Ausnahme der Reflektorschicht beim ersten Ausführungsbeispiel denen des ersten Ausführungsbeispiels.

Somit wird entsprechend dem Hintergrund des ersten Ausführungsbeispiels ein Verfahren zur Herstellung von Farbpigmenten vorgesehen, wobei auf eine Reflexionschicht zumindest eine eine Farbänderung von reflektiertem Licht bewirkende Schicht aufgebracht wird, wobei die Schicht ein transparente Schichten bildendes Material - im folgenden transparentes Material genannt - mit einem vorbestimmten Brechungsindex n von vorzugsweise größer als 1.8 enthält, dem zumindest ein lichtabsorbierendes Material beigemischt wird.

Entsprechend dem Hintergrund des zweiten Ausführungsbeispiels ist Verfahren zur Herstellung von Farbpigmenten mit zumindest einer eine Farbänderung von reflektiertem Licht bewirkende Schicht vorgesehen, wobei auf eine niedrigbrechende Schicht die zumindest eine die Farbänderung von reflektiertem Licht bewirkende Schicht aufgebracht wird, wobei die zumindest eine die Farbänderung von reflektiertem Licht bewirkende Schicht hochbrechend ist und ein transparentes Material aufweist, dem zumindest ein lichtabsorbierendes Material beigemischt wird.

**Patentansprüche**

1. Verfahren zur Herstellung von reflektierenden Farbpigmenten, wobei auf eine Reflexionschicht (2) zumindest eine eine Farbänderung von reflektiertem Licht bewirkende Schicht (1) aufgebracht wird, **dadurch gekennzeichnet, daß** die Schicht (1) in einem PVD-Verfahren unter Vakuum von $10^{-1}$ bis $10^{-3}$ Pa mit einer Schichtdicke von n x d $=\lambda/4$ bis $3\lambda/4$, wobei $\lambda$ die Wellenlänge, n der-Brechungsindex und d die geometrische Dicke ist aufgebracht wird und aus einem transparente Schichten bildenden Material - im folgenden transparentes Material genannt - mit einem vorbestimmten Brechungsindex von größer als 1.8 besteht, dem zumindest ein lichtabsorbierendes Metall im selben PVD-Prozeß gleichzeitig und in wählbarer Menge beigemischt wird.

2. Verfahren nach Anspruch 1, wobei die reflektierenden Farbpigmente eine Lichtdurchlässigkeit im sichtbaren Bereich von weniger als 20 Prozent haben.

3. Verfahren nach einem der Patentansprüche 1 und 2, wobei das lichtabsorbierende Metall in einem Molverhältnis zwischen 1 und 50 % dem transparenten Material durch gleichzeitige Verdampfung unter Vakuum beigemischt wird.

4. Verfahren nach Patentanspruch 3, **dadurch gekennzeichnet, daß** die Beimischung durch Überlappung der Dampfstrahlen des transparenten Materials und des lichtabsorbierenden Metalls durchgeführt wird.

5. Verfahren nach Patentanspruch 3 oder 4, **dadurch gekennzeichnet, daß** die Verdampfung unter Vakuum aus zwei getrennten, geregelten Quellen (6,7; 9,10) erfolgt, welche vorzugsweise widerstandsbeheizte, mit Elektronenstrahlen beheizte, mit einer Frequenz von 2 Kilohertz bis 3 Gigahertz induktiv beheizte oder mit einem Lichtbogen betriebene Verdampfer (6, 7; 9, 10) sein können.

6. Verfahren nach einem der vorhergehenden PatentanSprüche, **dadurch gekennzeichnet, daß** das transparente Material ein Oxid oder Suboxid von Titan, Zirkonium, Nioboxid oder auch das Metall selbst dieser Oxide oder Suboxide, oder ein Metall oder Metallgemisch der Seltenen Erden ist.

**7.** Verfahren nach Patentanspruch 6, **dadurch gekennzeichnet, daß** die Oxide, Suboxide oder Metalle als Mischung gleichzeitig aus derselben oder aus getrennten Quellen aufgedampft werden.

**8.** Verfahren nach einem der vorhergehenden Patentansprüche, **dadurch gekennzeichnet, daß** als lichtabsorbierendes Metall Chrom, Nickel, Vanadium, Eisen, Mangan oder Molybdän oder eine Legierung, welche eines oder mehrere dieser Metalle enthält, verdampft werden.

**9.** Verfahren nach einem der Patentansprüche 1 bis 8, **dadurch gekennzeichnet, daß** als lichtabsorbierendes Metall eine intermetallische Verbindung verdampft wird, beispielsweise Silicide.

**10.** Verfahren nach einem der vorhergehenden Patentansprüche, **dadurch gekennzeichnet, daß** zur Herstellung der Reflexionsschicht (2) eines der Metalle Aluminium, Silber, Chrom, Nickel, Eisen, Mangan, Vanadium, Niob, Titan, Zirkonium, Silizium oder Molybdän oder eine Legierung, die eines oder mehrere dieser Metalle enthält, verdampft werden, wobei die Lichtdurchlässigkeit der Reflexionsschicht (2) vorzugsweise zwischen 50 % und 0.001% beträgt.

**11.** Verfahren nach einem der vorhergehenden Patentansprüche **dadurch gekennzeichnet, daß** die Schicht (1) auf einer oder auf beiden Seiten der Reflexionsschicht (2) aufgebracht wird, wobei beim Aufbringen auf beide Seiten die Dicke der Schichten (1) auf der Reflexionsschicht (2) unterschiedlich sein kann.

**12.** Verfahren nach einem der vorhergehenden Patentansprüche, **dadurch gekennzeichnet, daß** die Schichten (1,2) auf ein vorzugsweise umlaufendes Trägermaterial (5) aufgebracht, vorzugsweise aufgedampft werden, wobei zwischen Trägermaterial (5) und dem Schichtaufbau ein Trennmittel aufgebracht wird.

**13.** Verfahren nach einem der Patentansprüche 1, 2, 6 bis 12, wenn diese nicht von den Patentansprüche 3 bis 5 abhängen, **dadurch gekennzeichnet, daß** die Reflexionsschicht (2) Schicht auf das Trägermaterial (5) aufgebracht wird und nach dem Ablösen dieses Schichtaufbaus in einem nachfolgenden Arbeitsgang die Schicht (1) bei einer Temperatur zwischen Raumtemperatur und 750°C unter Anwesenheit eines sauerstoffhaltigen Gases aufgebracht wird.

**14.** Verfahren nach Patentanspruch 12 oder 13 **dadurch gekennzeichnet, daß** das zur Ablösung des Schichtenverbundes vom bandförmigen Trägermaterial notwendige Trennmittel im selben Vakuumprozeß vor dem Aufdampfen des Schichtenverbundes aufgetragen wird.

**15.** Verfahren nach einem der Patentansprüche 12 bis 13, **dadurch gekennzeichnet, daß** das Trägermaterial (5) aus einer Polyimidfolie von vorzugsweise mehr als 12 Mikrometer Dicke oder aus einem Metallband von vorzugsweise 9 bis 1000 Mikrometer Dicke oder aus einer Kombination beider besteht.

**16.** Verfahren nach einem der Patentansprüche 12 bis 15, **dadurch gekennzeichnet, daß** das bandförmige Trägermaterial als umlaufend geschlossenes Band (5) ausgebildet ist und die einzelnen Prozeßschritte wie das Aufbringen des Trennmittels, das Bedampfen und die Ablösung des Produktes nacheinander erfolgen, wobei die Ablösestation allein oder zusammen mit der das Trennmittel aufbringenden Station durch mehrstufige, dynamische Vakuumschleusen getrennt bei Atmosphärendruck betrieben wird.

**17.** Verfahren nach einem der vorhergehenden Patentansprüche, **dadurch gekennzeichnet, daß** sich an das Aufbringen der Schicht (1) eine oxidativ-thermische Nachbehandlung des die transparente Schicht ausbildenden Materials anschließt.

**18.** Farbpigment, insbesondere hergestellt nach einem Verfahren gemäß einem der vorhergehenden Patentansprüche 1 bis 17, mit einer Reflexionsschicht (2), auf der zumindest eine Schicht (1) bestehend aus transparentem Material und lichtabsorbierendem Metall aufgebracht ist.

**Revendications**

**1.** Procédé pour produire des pigments colorants réfléchissants, dans lequel au moins une couche (1) déterminant un changement de couleur de la lumière réfléchie est appliquée sur un revêtement réflecteur (2), **caractérisé en ce que** la couche (1) est appliquée au cours d'un procédé en phase vapeur sous un vide de $10^{-1}$ à $10^{-3}$ Pa pour une épaisseur de couche n x d = de $\lambda/4$ à $3\lambda/4$, où $\lambda$ est la longueur d'onde, n l'indice de réfraction et d l'épaisseur géométrique, et **en ce que** ladite couche (1) consiste en un matériau formant une couche transparente - désigné par la suite par matériau transparent - doté d'un indice de réfraction prédéterminé supérieur à 1,8, et auquel au moins un métal absorbant la lumière est ajouté au cours du même procédé en phase vapeur et dans une quantité déterminée.

**2.** Procédé selon la revendication 1, dans lequel les pigments colorants réfléchissants sont dotés d'un coefficient de transmission dans le domaine visible inférieur à 20 pour cent.

**3.** Procédé selon l'une des revendications 1 et 2, dans lequel le métal absorbant la lumière est mélangé, par vaporisation simultanée sous vide, au matériau transparent selon un rapport molaire allant de 1 à 50 %.

**4.** Procédé selon la revendication 3, **caractérisé en ce que** le mélange est effectué par chevauchement des jets de vapeur du matériau transparent et du métal absorbant la lumière.

**5.** Procédé selon la revendication 3 ou 4, **caractérisé en ce que** la vaporisation sous vide est réalisée à partir de deux sources distinctes et réglées (6, 7 ; 9, 10), lesquelles peuvent être de préférence des évaporateurs chauffés par résistance, par faisceau d'électrons, chauffés de manière inductive avec une fréquence de 2 kilohertz à 3 giga hertz ou activés par un arc électrique (6, 7 ; 9, 10).

**6.** Procédé selon l'une des revendications précédentes, **caractérisé en ce que** le matériau transparent est un oxyde ou un sous-oxyde de titane, de zirconium, de niobium ou également le métal lui-même de ces oxydes ou sous-oxydes, ou un métal ou un mélange métallique de terres rares.

**7.** Procédé selon la revendication 6, **caractérisé en ce que** les oxydes, sous-oxydes ou métaux sont déposés de manière simultanée sous forme de mélanges à partir d'une même source ou de sources distinctes.

**8.** Procédé selon l'une des revendications précédentes, **caractérisé en ce que** le chrome, le nickel, le vanadium, le fer, le manganèse ou le molybdène ou un alliage, lequel contient un ou plusieurs de ces métaux, sont vaporisés comme métal absorbant la lumière.

**9.** Procédé selon l'une quelconque des revendications 1 à 8, **caractérisé en ce qu'**un composé intermétallique, comme par exemple du siliciure (silicide), est vaporisée en tant que métal absorbant la lumière.

**10.** Procédé selon l'une des revendications précédentes, **caractérisé en ce que** l'un des métaux suivants aluminium, argent, chrome, nickel, fer, manganèse, vanadium, niobium, titane, zirconium, silicium ou molybdène ou un alliage qui contient un ou plusieurs métaux, est vaporisé pour la production du revêtement réflecteur (2), moyennant quoi le coefficient de transmission du revêtement réflecteur (2) se situe de préférence entre 50 % et 0,001 %.

**11.** Procédé selon l'une des revendications précédentes, **caractérisé en ce que** la couche (1) est appliquée sur une face ou sur les deux faces du revêtement réflecteur (2), auquel cas lors de l'application sur les deux faces, l'épaisseur des couches (1) peut être différente au niveau du revêtement réflecteur (2).

**12.** Procédé selon l'une des revendications précédentes, **caractérisé en ce que** la couche (1) et le revêtement (2) sont appliqués, de préférence vaporisés, sur un substrat (5) de préférence rotatif, un agent séparateur étant appliqué entre le substrat (5) et la formation de la couche.

**13.** Procédé selon l'une quelconque des revendications 1, 2, 6 à 12, si celles-ci ne dépendent pas des revendications 3 à 5, **caractérisé en ce que** le revêtement réflecteur (2) est appliqué en couche sur le substrat (5) et après la séparation de cette formation de couche, au cours d'une étape suivante, la couche (1) est appliquée à une température située entre la température ambiante et 750° C en présence d'un gaz contenant de l'oxygène.

**14.** Procédé selon la revendication 12 ou 13 **caractérisé en ce que** l'agent séparateur nécessaire à la séparation de la liaison de couche du substrat en forme de bande est appliqué lors du même processus sous vide avant la vaporisation de la liaison de couche.

**15.** Procédé selon l'une quelconque des revendications 12 à 13, **caractérisé en ce que** le substrat (5) consiste en une feuille en polyimide de préférence de plus de 12 micromètres d'épaisseur ou en une bande métallique de préférence de 9 à 1000 micromètres d'épaisseur ou d'une combinaison des deux.

**16.** Procédé selon l'une quelconque des revendications 12 à 15, **caractérisé en ce que** le substrat en forme de bande est constitué comme une bande (5) fermée de manière circulaire et les diverses étapes du processus, telles que l'application de l'agent séparateur, la métallisation dans le vide et la séparation du produit, sont effectuées de manière successive, l'installation de séparation étant utilisée à la pression atmosphérique seule ou conjointement à l'installation permettant l'application de l'agent séparateur, séparées par des sas dynamiques sous vide comportant plusieurs niveaux.

**17.** Procédé selon l'une des revendications précédentes, **caractérisé en ce que** un traitement thermique oxydant consécutif appliqué au matériau formant la couche transparente est adjoint à la déposition de la couche (1).

**18.** Pigment colorant doté d'un revêtement réflecteur (2), et produit en particulier conformément à un procédé selon l'une quelconque des revendications précédentes 1 à 17, est appliqué sur au moins une couche (1) consistant en un matériau transparent et en un métal absorbant la lumière.

**Claims**

**1.** A method for producing reflecting color pigments, wherein on a reflection layer (2) at least one layer (1) causing a color change of reflected light is applied, **characterized in that** the layer (1) is applied in a PVD process under a vacuum of $10^{-1}$ to $10^{-3}$ Pa at a layer thickness of n x d = $\lambda/4$ to $3\lambda/4$, with $\lambda$ being the wavelength, n the refractive index, and d the geometrical thickness, and consists of a material which forms transparent layers - hereinafter referred to as 'transparent material' - having a predetermined refractive index n of greater than 1.8 to which at least one light absorbing metal is admixed concurrently during the same PVD process and in a choosable quantity.

**2.** The method according to claim 1, wherein the reflecting color pigments have a light transmission in the visible range of less than 20 per cent.

**3.** The method according to any one of claims 1 and 2, wherein the light absorbing metal is admixed to the transparent material in a molar ratio of between 1 and 50 % by concurrent evaporation under vacuum.

**4.** The method according to claim 3-, **characterized in that** admixture is performed by overlapping the vapor jets of the transparent material and of the light absorbing metal.

**5.** The method according to claim 3 or 4, **characterized in that** evaporation under vacuum takes place from two separate, controlled sources (6, 7; 9, 10) which may preferably be evaporators (6, 7; 9, 10) that are resistance heated, electron beam heated, inductively heated at a frequency of 2 kilohertz to 3 gigahertz, or electric arc operated.

**6.** The method according to any one of the preceding claims, **characterized in that** the transparent material is an oxide or suboxide of titanium, zirconium, niobium oxide, or also the very metal of these oxides or suboxides, or a metal or metal mixture of the rare earths.

**7.** The method according to claim 6, **characterized in that** the oxides, suboxides or metals may concurrently be vapor deposited as a mixture from the same source or from separate sources.

**8.** The method according to any one of the preceding claims, **characterized in that** as a light absorbing metal, chromium, nickel, vanadium, iron, manganese or molybdenum, or an alloy containing one or several of these metals are evaporated.

**9.** The method according to any one of claims 1 to 8, **characterized in that** as a light absorbing metal an intermetallic compound is evaporated, for example silicides.

**10.** The method according to any one of the preceding claims, **characterized in that** for production of the reflection layer (2) one of the metals aluminum, silver, chromium, nickel, iron, manganese, vanadium, niobium, titanium, zirconium, silicon or molybdenum or an alloy containing one or several of these metals are evaporated, with the light transmission of the reflection layer (2) preferably being between 50 % and 0.001 %.

**11.** The method according to any one of the preceding claims, **characterized in that** the layer (1) is applied an one or on both sides of the reflection layer (2), wherein the thicknesses of the layers (1) on the reflection layer (2) may be different when applied on both sides.

12. The method according to any one of the preceding claims, **characterized in that** the layers (1, 2) are applied, preferably vapor deposited, onto a preferably circulating carrier material (5), wherein a separating agent is applied between carrier material (5) and the layered structure.

13. The method according to any one of claims 1, 2, 6 to 12 where not dependent on claims 3 to 5, **characterized in that** the reflection layer (2) is applied onto the carrier material (5), and following stripping of this layered structure, layer (1) is applied at a temperature preferably between room temperature and 750° C in the presence of an oxygen-containing gas.

14. The method according to claim 12 or 13, **characterized in that** the separating agent required for stripping the layered compound from the tape-type carrier material is applied in the same vacuum process prior to vapor deposition of the layered compound.

15. The method according to any one of claims 12 to 13, **characterized in that** the carrier material (5) is comprised of a polyimide film having a thickness of preferably more than 12 micrometers or of a metal belt having a thickness of preferably 9 to 1,000 micrometers, or of a combination of the two.

16. The method according to any one of claims 12 to 15, **characterized in that** the tape-type carrier material has the form of a continuous circulating belt (5), and the single process steps such as application of the separating agent, vapor deposition and stripping of the product are performed successively, wherein the stripping station is operated singly or together with the station for application of the separating agent at atmospheric pressure while separated by multistage, dynamic vacuum locks.

17. The method according to any one of the preceding claims, **characterized in that** application of the layer (1) is followed by an oxidative-thermal aftertreatment of the material forming the transparent layer.

18. A color pigment, in particular produced in accordance with a method of one of the preceding claims 1 to 17, including a reflection layer (2), on which at least one layer (1) comprised of transparent material and light absorbing metal is applied.

Fig.1

Fig.2

Fig.3

Fig.4

EP 1 144 711 B1

**Fig. 5**